# Europäisches Patentamt

# European Patent Office

# Office européen des brevets

(11) Publication number: **0 143 005**
**B1**

# EUROPEAN PATENT SPECIFICATION

(45) Date of publication of patent specification: **07.11.90**

(21) Application number: **84308148.0**

(22) Date of filing: **23.11.84**

(51) Int. Cl.⁵: **H 03 M 5/14, G 11 B 20/14** // **H04L25/49, G06F5/00**

(54) Digital data converting methods and apparatus.

(30) Priority: **24.11.83 JP 221235/83**

(43) Date of publication of application:
**29.05.85 Bulletin 85/22**

(45) Publication of the grant of the patent:
**07.11.90 Bulletin 90/45**

(84) Designated Contracting States:
**AT BE CH DE FR GB IT LI NL**

(56) References cited:
**EP-A-0 143 553    GB-A-2 099 263**
**FR-A-2 468 968    US-A-3 631 471**
**FR-A-2 486 740    US-A-4 001 811**
**GB-A-2 056 225**

**IBM TECHNICAL DISCLOSURE BULLETIN, vol. 19, no. 7, December 1976, pages 2715-2717, New York, US; A.M.PATEL: "Charge-constrained byte-oriented(0,3) code"**

**PATENTS ABSTRACTS OF JAPAN, vol. 6, no. 258 (P-163)1136r, 17th December 1982; & JP-A-57 154 612**

(73) Proprietor: **SONY CORPORATION**
**7-35 Kitashinagawa 6-Chome Shinagawa-ku Tokyo 141 (JP)**

(72) Inventor: **Fukuda, Shinich c/o Patent Division Sony Corporation 7-35 Kitashinagawa-6 Shinagawa-ku Tokyo (JP)**

(74) Representative: **Thomas, Christopher Hugo et al D Young & Co 10 Staple Inn London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to digital data converting methods and apparatus. The methods and apparatus are suitable, for example, for use where an audio signal is pulse code modulated and then recorded.

Apparatus is known in which an analog signal such as an audio signal is converted into a pulse code modulated (PCM) signal, magnetically recorded using a rotary head without forming guard-bands, and then reproduced. In such known apparatus, in addition to a differentiated output characteristic of the magnetic recording and a low frequency cross-talk component generated from adjacent tracks, low frequency components are cut off by a rotary transformer, so the low frequency components of the audio signal cannot be reproduced with high fidelity.

Accordingly, in the above apparatus, which is required to have a narrow record and playback frequency band and a small low frequency component, it is effective to modulate a record signal into the area of the low frequency and direct current (DC) components by a modulating system having a small frequency spectrum component. The so-called non-return to zero, inverted (NRZI) modulation system is an example of such a modulation system. In the NRZI system, a signal is inverted at level "1" in the data signal, but is not inverted at level "0" therein.

However, in the NRZI modulation system, when consecutive digital zeroes appear, the modulated signal is not inverted during the period occupied by the digital zeroes, and the frequency of the modulated signal becomes low. Thus, the DC and the low frequency components are increased.

Therefore, it has been proposed to divide the PCM digital information into groups of bits of a predetermined number and to convert the respective groups of bits into groups of a large number, thereby avoiding the occurrence of a large number of consecutive digital zeroes.

We have previously proposed such an information converting system as follows.

In this converting system, eight bits ($B_1$, $B_2$, $B_3$, $B_4$, $B_5$, $B_6$, $B_7$, $B_8$) of digital information in a base digital signal are converted to ten bits ($P_1$, $P_2$, $P_3$, $P_4$, $P_5$, $P_6$, $P_7$, $P_8$, $P_9$, $P_{10}$). Eight bits ($B_1$, $B_2$, $B_3$, $B_4$, $B_5$, $B_6$, $B_7$, $B_8$) can be combined in $256(2^8)$ different ways.

With ten bits ($P_1$, $P_2$, $P_3$, $P_4$, $P_5$, $P_6$, $P_7$, $P_8$, $P_9$, $P_{10}$), in order to avoid a DC component (or charge) in the signal after the NRZI modulation, it is sufficient that five bits in ten bits are positive "1" and five bits are negative "0". In order to establish $T_{max}/T_{min} = 4$ (where $T_{max}$ is the maximum internal between level transistions and $T_{min}$ is the minimum interval between level transitions), a condition is required such that in n the NRZI-coding, the number of consecutive digital zeroes is less than three, or in the converted signal the number of consecutive bits of the same level is less than four.

With the above constraints, the following Table I shows the possible combinations of ten digital bits in the NRZI code for which the DC component is zero, but in which there are no more than three digital zeroes in a row (either internally of each 10-bit word or at the boundary between two such words):

### TABLE I

| | $\cdots\cdots 1$ | $\cdots\cdots 10$ | $\cdots\cdots 100$ | $\cdots\cdots 1000$ |
|---|---|---|---|---|
| $1 \cdots\cdots$ | 69 | 34 | 14 | 4 |
| $01 \cdots\cdots$ | 40 | 20 | 8 | 1 |
| $001 \cdots\cdots$ | 20 | 10 | 3 | 1 |
| $0001 \cdots\cdots$ | 8 | 3 | 2 | 1 |

Table I shows that there are numerous possible combinations that will satisfy the constraints. For example, if up to three digital zeroes are permitted at the beginning of each word, then no digital zeroes can be permitted at the end of any word. In that case, Table I shows the total of the possible combinations is:

$$137 = 69 + 40 + 20 + 8$$

From all of the combinations in Table I, the maximum total is achieved if no more than two digital zeroes are permitted at the beginning of a 10-bit converted word and no more than one digital zero is permitted at the end. In that case, the total is:

$$193 = 69 + 40 + 20 + 34 + 20 + 10$$

Thus, 193 10-bit combinations are available for which the DC component is zero. These are called "primary combinations".

Since there are 256 possible 8-bit words of original data, 63 additional 10-bit combinations are required to represent all of the original data. Thus, it is necessary to use 10-bit combinations for which the DC component is not zero.

The following table illustrates the number of possible 10-bit combinations, which begin with no more than two digital zeroes and end with no more than one digital zero, having a DC component of 0, −2 and +2 when NRZI-coded.

TABLE II

| first bit / DC | | −2 | | 0 | | +2 | |
|---|---|---|---|---|---|---|---|
| 1 ·· | 11 ······ | 52 | 40 | 103 | 60 | 100 | 43 |
| | 101 | | 11 | | 30 | | 30 |
| | 100 | | 1 | | 13 | | 27 |
| 01 ·· ·· ·· ·· | | 43 | | 60 | | 40 | |
| 001·· ·· ·· ·· | | 30 | | 30 | | 11 | |

From Table II, it is clear that the number of possible combinations in which the DC component is −2 is:

$$52 + 43 + 30 + 125$$

Also, it is clear that the number of possible combinations with +2 DC component is:

$$100 + 40 + 11 = 151$$

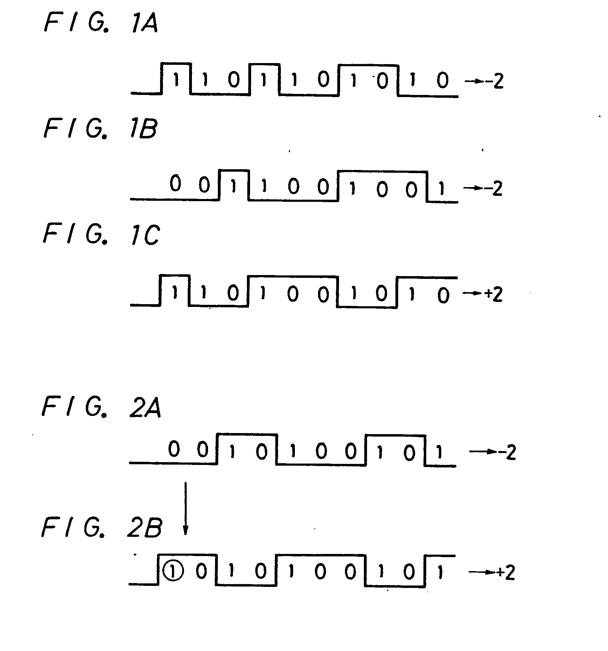

To calculate the DC components for Table II, it was assumed that the last bit of the next-preceding 10-bit combination was at the low level "0", as shown in Figures 1A to 1C of the accompanying drawings. If Table II were constructed by assuming that the level of the last bit of the preceding word was high "1", then "−2" and "2" columns would be interchanged as shown in Figures 2A and 2B.

Further, the low frequency spectrum of the modulation wave tends to decrease more if the combination alternately using the combination with +2 and −2 DC component is used more frequently than the combinations with a zero DC component. Accordingly, 125 combinations with a pair of +2 and −2 DC components are used and the remaining 131 combinations with a zero DC component are used for 256 combinations of eight bit, by which 125 combinations and 131 combinations are made corresponding respectively to 256 combinations of eight bits.

As the combinations with the pair of +2 and −2 DC components, the pair may be selected such that DC component can be controlled only by changing the first bit (the second bit and the following bits in combinations of a pair are formed as the same level). Therefore, of the possible combinations in, for example, Table II, the combinations with +2 and −2 DC components and the first bit beginning with "0":

$$40 + 11 + 43 + 30 = 124$$

are used. And, it is possible that 124 combinations and the combinations with a zero DC component, in this

EP 0 143 005 B1

case, 132 combinations are made corresponding respectively to 256 combinations of eight bits. Then, each time the combination with $\pm 2$ DC components appears, the first bit of the combination is converted in such a manner that the DC component becomes positive and negative alternately.

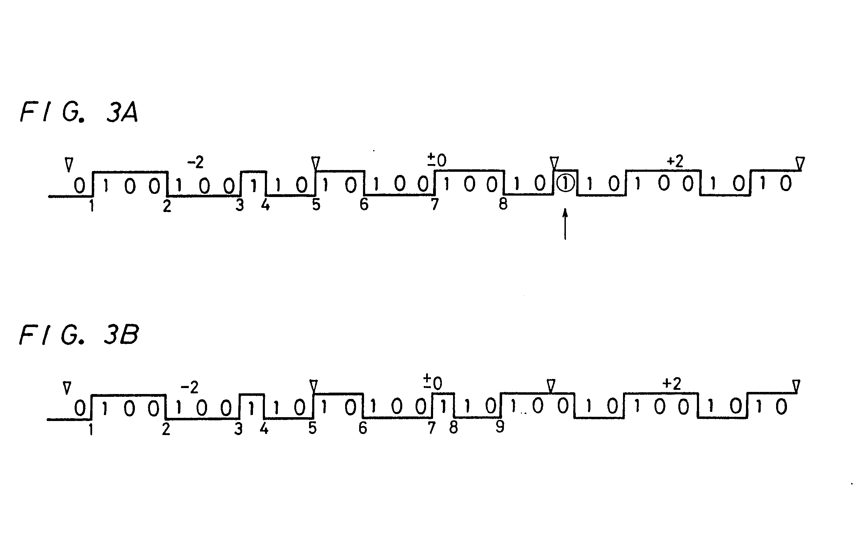

That is, as shown in Figures 3A and 3B of the accompanying drawings, when the combinations with $\pm 2$ DC components appears, the number of level transitions P (the number of digital ones) from the second bit is counted, in which until the following combination with $\pm 2$ DC components appears, if the number of level transitions is even, the first bit (shown by an inverted delta) is converted to digital one as shown in Figure 3A, while if the number of level transitions is odd, the first bit remains as digital zero as shown in Figure 3B.

Thus, even if $\pm 2$ DC components appear, they are cancelled out by $\pm 2$ DC components of the succeeding combination and hence regardless of any consecutive digital components, the DC component becomes zero.

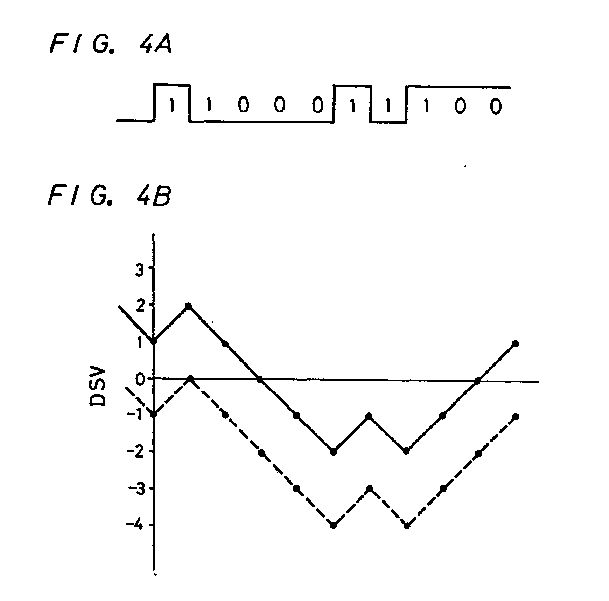

The DC component of each bit is generally called a digital sum variation (DSV), which is one of the evaluation methods. Let it be considered that a combination is formed of a 10-bit pattern with zero DC component as, for example, shown in Figure 4A of the accompanying drawings. When transition of DSV begins with DSV = 1, the change of the DSV of such a combination is as shown by a solid line in Figure 4B of the accompanying drawings.

If the width between the maximum and minimum values of the DSV is small, the DSV has a small DC component and the low frequency component is reduced. As one of the evaluation methods, there is further known a parameter which is generally referred to as DSV variance. The DSV variance can be obtained by squaring and averaging the DSV values at every bit, and it is desired that the DSV variance is as small as possible. While the level of DSV = 0 is defined as an average value of the DSV value of every bit, the level of DSV regarding the waveform of the combination (code) which has been NRZI-coded is defined as DSV max = −DSV min. Accordingly, in this case, it is convenient that the DSV at the boundary between the respective combinations is taken as +1 or −1 and the intermediate value between DSV max and DSV min is defined as DSV = 0.

Therefore, let us consider the above converting method by using the evaluation method of DSV variance. In the combination as, for example, shown in Fiugre 4A, when the evaluation of DSV variance begins with DSV = +1, the transistion of DSV changes along the solid line shown in Figure 4B as described above and the DSV variance at that time becomes 1.7. While, when the evaluation of the DSV variance begins with DSV = −1, the transition of DSV changes as shown by a broken line in Figure 4B, and the DSV variance at that time becomes 6.9. That is, combinations of the same bit pattern are made to have different DC characteristics depending on the initial setting of DSV. Particularly in this case, when the evaluation of DSV variance begins with DSV = −1, the DSV variance becomes large, which is not preferable.

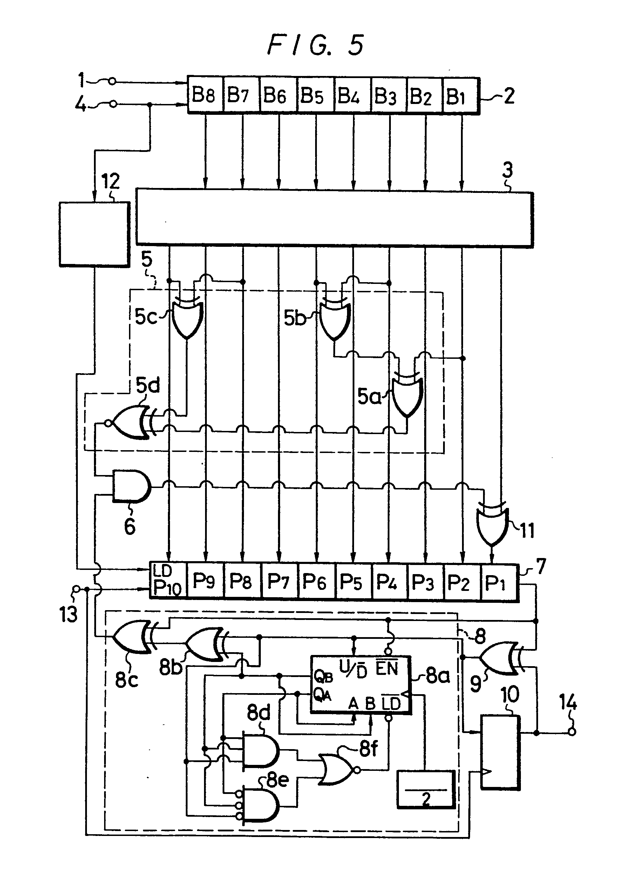

Figure 5 of the accompanying drawings shows an example of an apparatus which is capable of conversion in accordance with the above converting system. The apparatus comprises an input terminal 1, an 8-bit shift register 2 which accepts information of eight bits, a conversion logic circuit 3 which uses, for example, a programmable logic array (PLA), and a clock terminal 4. Then, information applied to the input terminal 1 is transferred eight bits at a time through the shift register 2 in response to a pulse which is applied to the clock terminal 4 at the data bit rate, and the information of eight bits ($B_1$, $B_2$, $B_3$, $B_4$, $B_5$, $B_6$, $B_7$, $B_8$) is supplied to the conversion logic circuit 3.

An identifying circuit 5 identifies whether the first bit is variable or fixed, namely, in this case, whether the DC component of the combination is "0" or +2. The identifying circuit 5 consists of, for example, exclusive-OR (hereinafter simply referred to as EOR) circuits 5a to 5c and an exclusive-NOR (hereinafter simply referred to as ENOR) circuit 5d. In the identifying circuit 5, the circuits 5a to 5d carry out modulo addition of the even-numbered bits of the output from the conversion logic circuit 3. In other words, the identifying circuit 5 detects whether the number of digital zeroes of the even-numbered bits is even or odd. If it is 0 (even), the identifying circuit 5 identifies that the combination has $\pm 2$ DC components and produces high level "1" at its output side, namely, the output side of the ENOR circuit 5d. That is, the identifying circuit 5 carries out all EOR logic operations of the even-numbered bit outputs of the output of the conversion logic circuit 3. In this case, when the even-numbered bit is "1", the level transition is carried out in this portion so that the DC components of this bit and the immediately preceding bit become 0. While, when the even-numbered bit is "0", there exist $\pm 2$ DC components. Further, when there are two digital zeroes, the DC component becomes 0 to $\pm 4$. In like manner, when there are three digital zeroes, the DC component be becomes $\pm 2$ or $\pm 6$. In other words, if the number of digital zeroes is even, the DC component becomes 0, $\pm 4$, $\pm 8$, ... , while if it is odd, the DC component becomes $\pm 2$, $\pm 6$, $\pm 10$, ... , . On the other hand, the whole of the DC component of ten bits is restricted to 0 or −2. Accordingly, by detecting whether the number of digital zeroes of the above even-numbered bit is even or odd, it is possible to identify whether the DC component is 0 or $\pm 2$.

The output of the identifying circuit 5 is supplied to one input terminal of an AND circuit 6, and the AND circuit 6 is supplied at its other input terminal with an output from a detecting circuit 8 which is provided at the output side of the shift register 7 for detecting the DC component (DSV) of each combination. The detecting circuit 8 supplied the high level output to the input side of the AND circuit 6 when the DC component DSV' up to the preceding combination is, for example, −1.

The output of the AND circuit 6 is supplied to one input terminal of an EOR circuit 11 which inverts the

4

first bit level. To the other input terminal of the EOR circuit 11 is supplied the first bit $P_1$ of ten bits from the conversion logic circuit 3. Accordingly, when the output of the AND circuit 6 if "0", the first bit $P_1$ is not inverted in level and fed as it is to the shift register 7, while even when the output of the AND circuit 6 is "1", the first bit $P_1$ is inverted in polarity and fed to the shift register 7.

Further, in Figure 5, an EOR circuit 9 and a D-type flip-flop circuit 10 constitute an NRZI-modulating circuit.

The detecting circuit 8 includes an up-down counter 8a, and the counter 8a is driven by a clock $\frac{1}{2}$ frequency to count only the even-numbered bits. Further, the up-down counter 8a is controlled by the output from the EOR circuit 9, so the DC component is detected. Since the output of the up-down counter 8a is always delayed by two bits, the EOR circuits 8b and 8c are provided to correct the count value of the counter 8a by the last two bits.

In the detecting circuit 8, AND circuits 8d and 8e and a NOR circuit 8f are used initially to set the DC component DSV to −1 or +1. When the DSV of the NRZI-modulated wave is counted by the counter 8a at every one or two bits, if the state of the DSV is taken as DSV is less than or equal to 3 in the range of DSV, there exist many DC components such as −3, −2, −1, 0, +1, +2 and +3. Accordingly, the DSV is initially set to −1 or +1 by the AND circuits 8d and 8e and the NOR circuit 8f.

Thus, the positive or negative polarity of the DC component is detected, and this detected signal and the signal from the identifying circuit 5 are supplied to the AND circuit 6 which then produces a control signal for controlling the level of the first bit of the output.

As to the combination of DC component in which it is a combination with zero DC component and a combination with ±2 DC components, the conversion logic circuit 3 is arranged to produce it to be any one of them as unified. When the conversion logic circuit 3 produces the output which is unified such that the DC component is −2, if the converted combination has −2 DC component and the evaluation of DSV' variance with −1, the first bit thereof is inverted by the EOR circuit 11 (at this time, the output of the AND circuit 6 is high level) and a combination having +2 DC component is then produced. Since the output of the identifying circuit 5 is low level and the output of the AND circuit 6 is also low level for the combination with a zero DC component, it is directly produced without the first bit being inverted in level by the EOR circuit 11.

A timing detector circuit 12 detects the timing of the pulse which is supplied to the clock terminal 4 at the data bit rate, and the timing signal from the timing detector circuit 12 is supplied to a load terminal LD of the shift register 7 at every 8-bit data.

As described above, the content or data converted to the form of 10-bit data and latched in the shift register 7 is sequentially read out therefrom on the basis of a clock signal with frequency 5/4 times the clock frequency of the input signal supplied thereto from a clock terminal 13. The signal thus read out from the shift register 7 is supplied to and NRZI-coded by the NRZI-modulating circuit which comprises the EOR circuit 9 and the flip-flop circuit 10, and is then fed to an output terminal 14.

In the case of the circuit arrangement in which PLA is used for the conversion logic circuit 3 as described above, the circuit for detecting whether the combination has zero DC component of +2 DC component is required so that the circuit arrangement becomes complicated. This poses no problem when a read-only memory (ROM) is used as the conversion logic circuit 3. However, the ROM causes the circuit arrangement to become large, and when this ROM is formed in an integrated circuit, the ROM occupies a large pattern area and consumes much power. Further, in order to make the DSV variance small, it is desired that two combinations having zero DC component are paired as much as possible, and that one of the pair having a smaller DSV variance is used on the basis of whether the DSV is +1 or −1. In this case, a detecting circuit is required to detect whether or not the first bit of the pair of the two combinations having the equal zero DC component is variable. This makes the circuit arrangement more complicated.

Further, if a pair of two combinations are not limited to ones in which bits succeeding the second bit are equal, but are selected from one having a small DSV variance, although the DSV variance can be made smaller, it is unavoidable that the circuit arrangement becomes more and more complicated.

Further, if a pair of two combinations are not limited to one in which bits succeeding the second bit are equal, but are selected from ones having a small DSV variance, although the DSV variance can be made smaller, it is unavoidable that the circuit arrangement becomes more and more complicated.

Therefore, a converting system has been considered which uses no detecting circuit.

In this converting system, when the combination in which DC component is zero is used, all the first bits thereof are converted similarly to the combination in which the DC component is ±2. To this end, even when the first bit is inverted, possible combination must be formed in $2 \times 2^m$ different ways, or the 8/10-conversion scheme must have 2 × 256 possible combinations. It is therefore assumed that $T_{max} = 5T'$ ($T' = T_{min} = T_w$ (window margin of detecting window)). Then, the number of the usable combinations is 512 or above.

The following Table III shows the number of possible combinations of 10-bit iformation which can satisfy the condition of $T_{max} = 5T'$. In this case, to satisfy the condition of $T_{max} = 5T'$, in NRZI code, the number of consecutive digital zeroes must never exceed four, or the same consecutive levels of digital signal after being modulated must never exceed five bits. Therefore, the bits must begin with at most two digital zeroes and also end with at most two digital zeroes.

5

TABLE III

| first bit | DC | −2 | | 0 | | +2 | |
|---|---|---|---|---|---|---|---|
| 1 ... | 11 ... ... | | 51 | | 68 | | 52 |
| | 101 ... | 71 | 17 | 120 | 34 | 120 | 34 |
| | 1001 ... | | 3 | | 18 | | 34 |
| 0 ... | 01 ... ... | | 52 | | 68 | | 51 |
| | 001... ... | 86 | 34 | 102 | 34 | 68 | 17 |

In Table III, the information or word beginning with "100 ...", if the first bit thereof is inverted, becomes "000...", so that three consecutive digital zeroes are permitted at the beginning thereof. There is then a risk that four or more consecutive digital zeroes will occur at the boundary between the consecutive combinations, thus such combinations cannot be used in this converting method. As a result, if these 55 (3 + 18 +34) combinations are removed from all the possible combinations in Table III, 512 combinations are left, which is just twice the number of possible combinations of $2^8 = 256$.

Accordingly, 256 possible combinations each of which forms a pair with a different first bit can be made corresponding to 256 possible combinations of 8-bit data. In this connection, Table III shows 102 possible combinations each of which forms a pair having a zero DC component and has a different first bit, and 154 possible combinations each of which forms a pair having ±2 DC components and has a different first bit.

Upon conversion, the pair of combinations are selected by detecting which of DSV = +1 or −1 make the DSV variance small. As described above in connection with Figure 4, when the DC component is −2, the evaluation of DSV variance begins with DSV = +1, while the DC component is +2, the evaluation of DSV variance begins with DSV = −1.

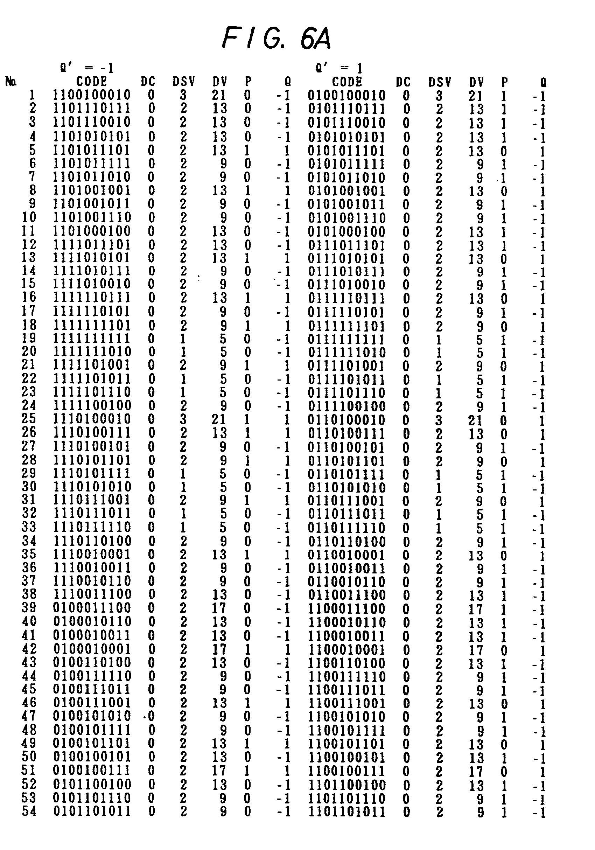

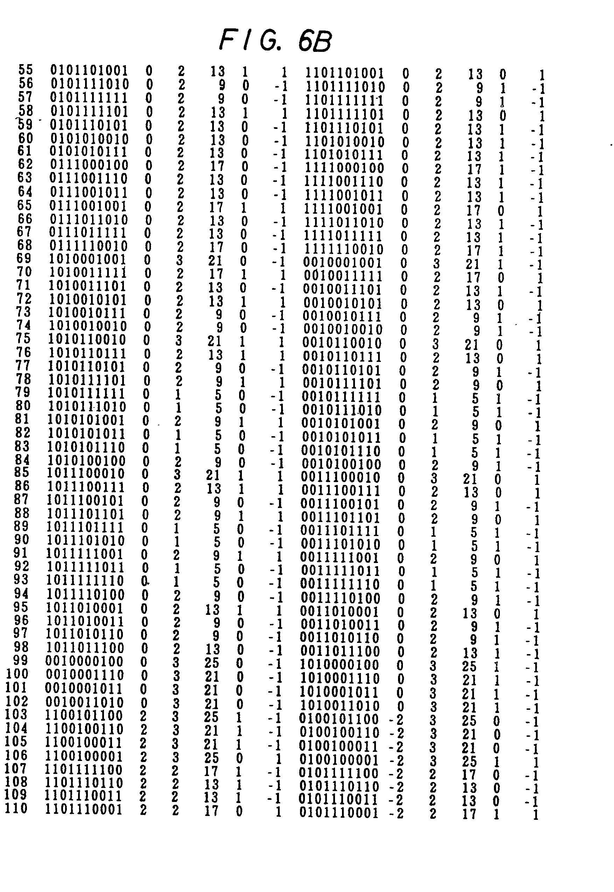

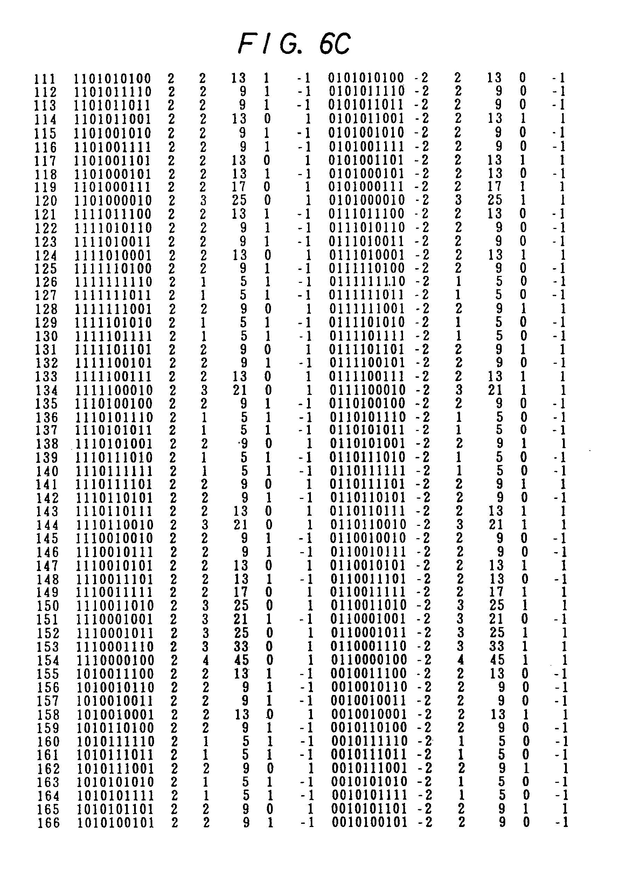

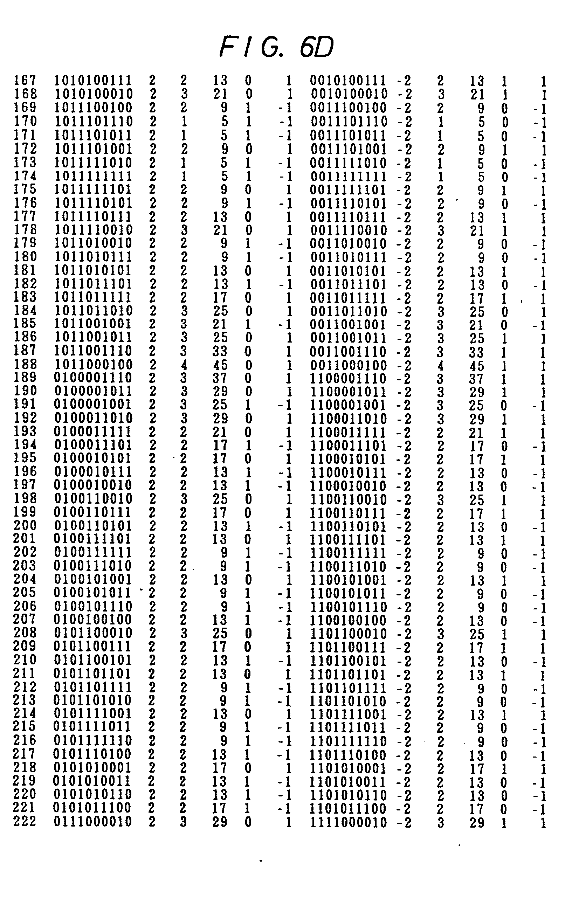

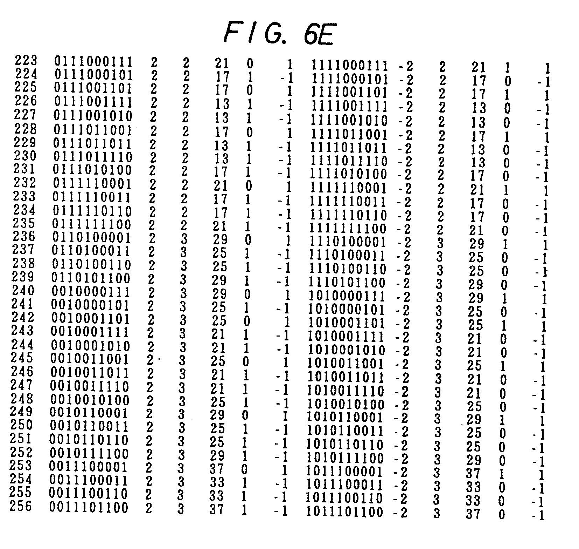

Figure 6 of the accompanying drawings (formed of Figures 6A to 6E) shows examples of 356 possible combinations (codes) which are selected on the basis of Table III, in which they are not corresponded to the data. Figure 6 shows that a pair of two combinations should be selected only by controlling, for example, the first bit. In Figure 6, reference Q' designates the DC component information (corresponding to the preceding DSV = DSV') of the code (combination) before being converted, DV designated the variance of DSV, P designates the number of level transitions (even number is 0 and odd number is 1) in each code, and Q designates the DC component information (corresponding to the DSV of the code just after being converted) of the code just after being converted. When the example of the circuit arrangement shown in Figure 5 uses the code of combinations in Figure 6, a pair of codes from numbers 1 to 102 having zero DC component are used individually.

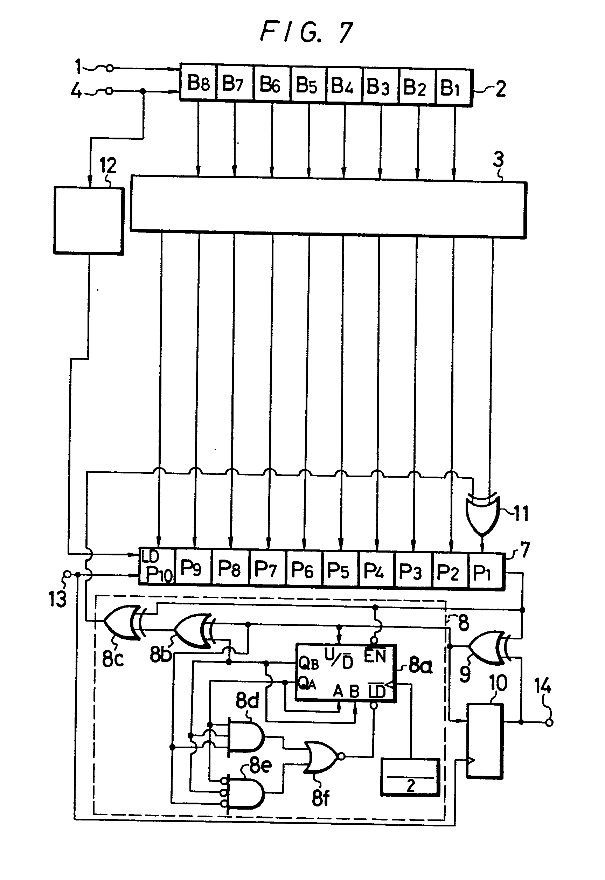

Figure 7 schematically illustrates an example of an apparatus which carries out the conversion in accordance with this converting method. In Figure 7, like parts corresponding to those in Figure 5 have the same references and will not be described in detail.

In the example shown in Figure 7, upon conversion, the first bit of all the possible combinations is made variable so that a circuit for detecting whether the first bit is variable or fixed, namely, the circuit 5 as shown in Figure 5 which detects whether the combination is the combination having zero DC component (the first bit is fixed) or or the combination having the +2 DC components (the first bit is variable) or the like is not necessary.

Therefore, in this example, the output of the detecting circuit 8 which detects the DC component (DSV) is directly supplied to one input terminal of the EOR circuit 11. Other arrangements are formed similarly to Figure 5.

The conversion logic circuit 3 produces its output with the first bit unified such that the preceding DSV' becomes −1 or +1. Accordingly, let it be assumed that DSV' = +1 be unified for the first bit. Then, when the converted combination begins with DSV' = −1, it is sufficient that the high level output of the detecting circuit 8 is supplied to the ERO circuit 11, in which the first bit thereof is inverted in level and then supplied to the shift register 7.

Accordingly, similarly to the above, the content or data of the shift register 7 is read out therefrom in response to the clock signal from the clock terminal 13, supplied through the EOR circuit 9 to the flip-flop circuit 10 and then developed at the output terminal 14 as the signal which is NRZI-coded.

As mentioned above, without using the detecting circuit 5 (and the AND circuit 6) as shown in Figure 5, it is possible to carry out the eight to ten conversion.

However, in the case of the prior circuit as mentioned above, since the waveform NRZI-coded in each combination is used to count the DC component, the detecting circuit 8 which detects the DC component becomes complicated in construction and becomes expensive in manufacturing cost.

The methods and apparatus as discussed above are generally as disclosed in our European patent specification EP—A1—0 143 553 (EPC Article 54(3)).

According to the present invention there is provided a method of converting a digital signal into a non-return to zero, inverted-coded signal, the method comprising the steps of:

a) dividing a basic digital signal into a series of basic words, each word having m bits of data;

b) converting said basic words into converted words, each of said converted words having n bits of data, wherein n is greater than m + 1, the series of converted words comprising a predetermined maximum number of consecutive digital zeroes;

c) said converted words comprising primary combinations of n bits having a DC component equal to zero when NRZI-coded, and pairs of secondary combinations of n bits having a DC component with a magnitude of two when NRZI-coded, the DC component of the combinations of each being of opposite polarity, and the pairs being chosen to differ only in the first bit of data thereof;

d) generating a control signal in response to the digital sum variation in the series of converted words preceding the respective word to be converted in response to the detection of a primary or a secondary combination, by forming a first signal indicating if the number of digital zeroes in the respective word to be converted is even, and comparing said first signal with the preceding control signal for generating the respective control signal;

e) selectively inverting the first bit of data of a secondary combination in response to said control signal; and

f) generating from said converted words said NRZI-coded signal.

According to the present invention there is also provided a method of converting a digital signal into a non-return to zero, inverted-coded signal, the method comparing the steps of:

a) dividing a basic digital signal into a series of basic words, each word having m bits of data;

b) converting said basic words into converted words, each of said converted words having n bits of data, wherein n is greater than m + 1, the series of converted words comprising a predetermined maximum number of consecutive digital zeroes;

c) said converted words comprising primary pairs of combinations of n bits having a DC component equal to zero when NRZI-coded, and pairs of secondary combinations of n bits having a DC component with a magnitude of two when NRZI-coded, the DC component of the combinations of each being of opposite polarity, and the primary and secondary combinations of each pair being chosen to differ only in the first bit of data thereof;

d) generating a control signal in response to the digital sum variation in the series of converted words preceding the respective word to be converted, by forming a first signal indicating if the number of digital zeroes in the respective word to be converted is even, and comparing said first signal with the preceding control signal for generating the respective control signal;

e) selectively inverting the first bit of data of a secondary combination in response to said control signal; and

f) generating from said converted words said NRZI-coded signal.

According to the present invention there is also provided apparatus for converting a digital signal into a non-return to zero, inverted-coded signal, the method comprising the steps of:

a) means for dividing a basic digital signal into a series of basic words, each word having m bits of data;

b) means for converting said basic words into converted words, each of said converted words having n bits of data, wherein n is greater than m + 1, the series of converted words comprising a predetermined maximum number of consecutive digital zeroes;

c) said converted words comprising primary combinations of n bits having a DC component equal to zero when NRZI-coded, and pairs of secondary combinations of n bits having a DC component with a magnitude of two when NRZI-coded, the DC component of the combinations of each being of opposite polarity, and pairs being chosen to differ only in the first bit of data thereof;

d) means for generating a control signal in response to the digital sum variation in the series of converted words preceding the respective word to be converted and in response to the detection of a primary or a secondary combination, by forming a first signal indicating if the number of digital zeroes in the respective word to be converted is even, and comparing said first signal with the preceding control signal for generating the respective control signal;

e) means for selectively inverting the first bit of data of a secondary combination in response to said control signal; and

f) means for generating from said converted words said NRZI-coded signal.

According to the present invention there is also provided apparatus for converting a digital signal into a non-return to zero, inverted-coded signal, the method comparing the steps of:

a) means for dividing a basic digital signal into a series of basic words, each word having m bits of data;

b) means for converting said basic words into converted words, each of said converted words having n bits of data, wherein n is greater than m + 1, the series of converted words comprising a predetermined maximum number of consecutive digital zeroes;

c) said converted words comprising primary pairs of combinations of n bits having a DC component equal to zero when NRZI-coded, and pairs of secondary combinations of n bits having a DC component with a magnitude of two when NRZI-coded, the DC component of the combinations of each being of opposite polarity, and the primary and secondary combinations of each pair being chosen to differ only in the first bit of data thereof;

d) means for generating a control signal in response to the digital sum variation in the series of converted words preceding the respective word to be converted, by forming a first signal indicating if the number of digital zeroes in the respective word to be converted is even, and comparing said first signal with the preceding control signal for generating the respective control signal;

e) means for selectively inverting the first bit of data of a secondary combination in response to said control signal; and

f) means for generating from said converted words said NRZI-coded signal.

The invention will now be described by way of example with reference to the accompanying drawings, throughout which like parts are referred to by like references, and in which:

Figures 1A to 1C respectively illustrate possible 10-bit combinations of an NRZI-coded converted digital signal;

Figure 2A illustrates a 10-bit combination of an NRZI-coded converted digital signal;

Figure 2B illustrates the 10-bit combination shown in Figure 2A with the first bit thereof inverted from a digital zero to a digital one;

Figures 3A and 3B respectively illustrate converted digital signals;

Figures 4A and 4B respectively illustrate a converted digital signal and variation of the DSV of the converted digital signal;

Figure 5 schematically illustrates an apparatus for generating an n-bit NRZI-coded converted digital signal from an m-bit base digital signal;

Figure 6 (formed of Figures 6A to 6E) is a diagram showing different 10-bit patterns;

Figure 7 schematically illustrates an apparatus for generating an n-bit NRZI-coded converted digital signal from an m-bit base digital signal;

Figure 8 schematically illustrates an embodiment of information converting apparatus according to the present invention; and

Figure 9 schematically illustrates another embodiment of information converting apparatus according to the present invention.

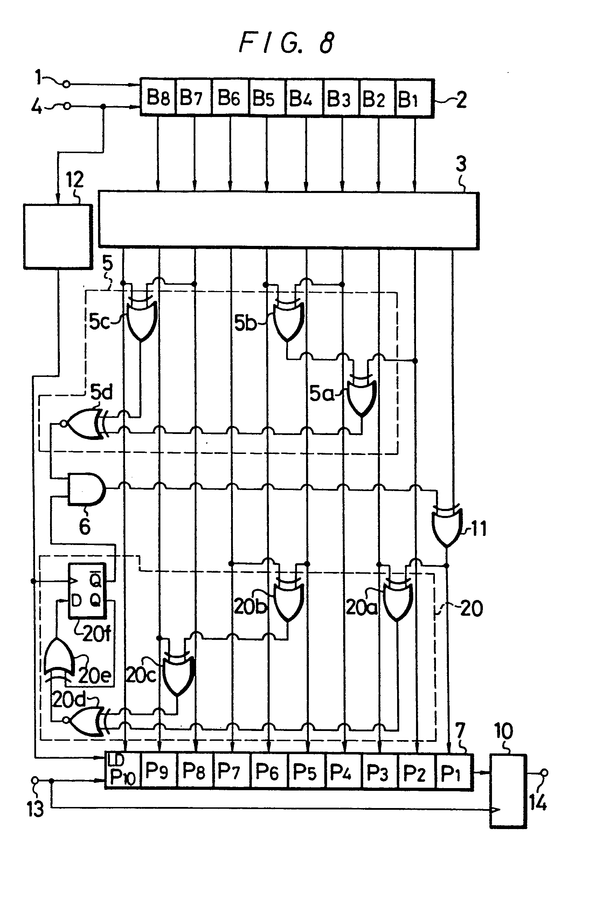

The embodiment of Figure 8 comprises a circuit arrangement corresponding to the example of the conversion for $T_{max} = 4T'$ which is based on Table II, namely, the example of the circuit shown in Figure 5. Accordingly, in Figure 8, like parts corresponding to those in Figure 5 are marked with the same references and will not be described in detail.

As described above, in the case of $T_{max} = 4T'$, there exist combinations having zero DC component (or charge) (the first bit is fixed) and ±2 DC components (the first bit is variable) so that they must be discriminated from each other. Accordingly, this embodiment uses the identifying or detecting circuit 5 as used in the example shown in Figure 5. In this case, a T-type flip-flop circuit, for example, is used as the flip-flop circuit 10.

For this embodiment, an explanation will be given for a case in which the DC component of a present combination for the succeeding combination can be calculated only by checking the parity of odd and/or even of an odd-numbered bit of the combination, without using the NRZI-coded waveform.

As described above, to detect whether the DC component of the combination is 0 or ±2, the even-numbered bit of the combination is taken into consideration. Then, if the number of digital zeroes is even, the DC component is 0 (DC = 0), while if it is odd, the DC component is regarded as ±2 (DC = ±2). In this case, let it be assumed that the detection information is Pe. And so, if Pe = 0, then the DC component is 0, while if Pe = 1, the DC components is ±2. Then, if the conversion logic circuit 3 produces its output of combination having the DC component DSV' = ±1 up to that time, when Pe = 1, the combination may be restricted as that with the −2 DC component. Accordingly, when Pe = 1 and DSV' = −1, the first bit of the combination is inverted in level to be the combination having 2 DC component.

Next, from the combination of n bits which were inverted in level as required, namely, 10-bit combinations in this case, the DC component is calculated for the succeeding combination. Let us assume that the parity of odd and/or even of the n-bit combination is P. Then, for zero DC component, if P = 0,

8

DSV = DSV' is established, while if P = 1, DSV = −DSV' is established. On the other hand, for the DC component of ±2, if P = 0, DSV = −DSV', while if P = 1, DSV = DSV'. The reason for this is as follows. ·When the DC component is 0, the DSV is not changed, so that DSV = DSV' is established. However, since the last bit of the NRZI-coded waveform in the waveform in the combination of P = 1 is the opposite level to the last bit of the preceding combination, if the DSV is defined assuming that the level of the last bit of the preceding combination is low level, that last bit of the present combination is high level, so that such level becomes the low level for the succeeding combination. In consequence, it is necessary to invert the code of the DC component information.

For the DC component of ±2, if P = 0, the state of the DC component is changed and the range in which the DC component is changed is limited from +1 to −1 or −1 to +1 so that DSV = −DSV' is finally established. On the other hand, when P = 1 is established, the level of the last bit is different from the level of the last bit of the preceding combination so that DSV = DSV' is finally established.

To summarize the above facts, only when the DC component is 0 and P = 1 and the DC component is ±2 and P = 0, it is sufficient for the DC component information that the DC component information of the preceding combination is inverted. The following Table IV shows the above in summarized form.

## TABLE IV

| DSV | DC | P | DSV | Pe | $P_0$ |
|---|---|---|---|---|---|
| 0 (−1) | - 0· | 0 | 0 | 0 | 0 |
| | | 1 | 1 | 0 | 1 |
| | +2 | 0 | 1 | 1 | 1 |
| | | 1 | 0 | 1 | 0 |
| 1 | 0 | 0 | 1 | 0 | 0 |
| | | 1 | 0 | 0 | 1 |
| | −2 | 0 | 0 | 1 | 1 |
| | | 1 | 1 | 1 | 0 |

In Table IV, reference $P_0$ designates odd and/or even parity for P and Pe. When the detecting information Pe is 0, the DC component is 0, while the detecting information Pe is 1, the DC component is ±2. Thus, under the condition that the modulo addition of P and Pe is expressed as $P_0$ ($P_0$ = P + Pe), when $P_0$ is 1, the level of the DC component DSV is inverted.

Further, Pe represents the parity indicative of the number of "O"s, although P represents the parity indicative of "1", if $n$ in the m/n-conversion is taken as even number, P may be the parity indicative of the number of "0"s. Accordingly, it is possible to say that P which is the odd and/or even parity of Pe and P is the parity indicative of the number of "0"s. That is, transmission information of the DC component is inverted, and then transmitted if the odd and/or even parity indicative of the number of "0"s at the odd-numbered bit of the combination is one.

Therefore, in this embodiment, there is provided a detecting circuit 20 for detecting the DC component, which comprises an EOR circuit 20a to which the first and third bits of ten bits of each combination are supplied, an EOR circuit 20b to which the fifth and seventh bits are supplied, an EOR circuit 20c to which the output from the EOR circuit 20b and the ninth bit are supplied, an ENOR circuit 20d to which the outputs from the EOR circuits 20a and 20c are supplied, and EOR circuit 20e which is supplied at one input terminal with the output from the ENOR circuit 20d, and a D-type flip-flop circuit 20f to which the output from the EOR circuit 20e is supplied. The output Q of the flip-flop circuit 20f is supplied to the other inputer terminal of the EOR circuit 20e, while the inverted output $\overline{Q}$ thereof is supplied to the other input terminal of the AND circuit 6.

The EOR circuits 20a to 20c take the parities of the odd-numbered bits. In this case, since the number of odd-numbered bits is five if the number $n$ is taken as ten, such parity is finally inverted by the ENOR circuit 20d as the parity indicative of the number of "0"s. When its value is 1, the output of the flip-flop circuit 20f is inverted by the EOR circuit 20e at the next stage. In other words, the preceding DC component information is inverted in level and then supplied to the flip-flop circuit 20f. Then, in order that when DSV' = −1, namely, the signal level is "0", the signal level "1" is supplied, the inverted output $\overline{Q}$ is derived from the flip-flop circuit 20f and then fed to the other input terminal of the AND circuit 6.

Consequently, the detecting circuit 20 produces the high level output when the DC component DSV' is −1.

On the other hand, as mentioned above, the identifying circuit 5 produces the high level output when the DC component is −2 so that the AND circuit 6 produces the signal "1" when the outputs of both the identifying circuit 5 and detecting circuit 20 are high level. Then, the output from the AND circuit 6 is supplied to one input terminal of the EOR circuit 11. At this time, the EOR circuit 11 inverts the first bit of the ten bits suppplied to the other input terminal thereof from the conversion logic circuit 3, and then supplies the first bit of the shift register 7.

As set forth above, in this embodiment, without using the NRZI-coded waveform, merely by checking the odd and/or even parity of the odd-numbered bits of each combination, it is possible to calculate the DC component for the succeeding combination so that the circuit arrangement can be simplified.

Since there exist two states of −1 DC component and +1 DC component ("0" and "1" in signal level)., DSV' may be either 1 or −1 at the beginning of the modulation. Accordingly, as shown in Figures 5 and 7, the circuit which uses the AND circuits 8d and 8e and the NOR circuit 8f initially to set the DC component DSV to +1 or −1 is not required.

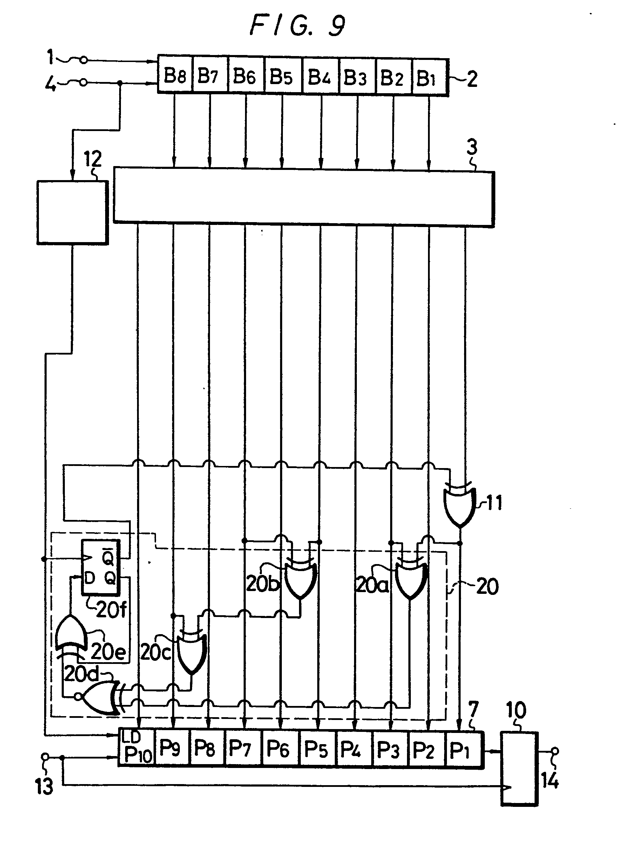

Figure 9 schematically illustrates another embodiment of the present invention. This embodiment corresponds to the example of the conversion of $T_{max} = 5T'$ based on Table III, namely, the example of the circuit shown in Figure 7. Accordingly, in Figure 9, like parts corresponding to those in Figure 7 are marked with the same reference and will not be described in details.

As described above, in the case of $T_{max} = 5T'$, the combination having zero DC component is used similarly to the combination having ±2 DC component in the state that all of the first bits are converted. As a result, it is not necessary to use the detecting circuit 5 which is used in Figure 8. Accordingly, in this case, only the detecting circuit for detecting the DC component is required, and hence the detecting signal circuit 20 used in Figure 8 is employed. In that case, the output of the detecting circuit 20, namely, the inverted output $\overline{Q}$ of the flip-flop circuit 20f is directly supplied to one input terminal of the EOR circuit 11.

Also in this case, if the output from the logic conversion circuit 3 is produced unified in the combination having, for example, DSV = +1, when the converted combination begins with DSV = 1, the high level output is supplied from the detecting circuit 20 to the EOR circuit 11, in which the first bit thereof is inverted and then fed to the shift register 7.

As described above, according to this embodiment, it is possible to achieve substantially similar action and effect to those of the first embodiment. In particular, this embodiment requires no identifying circuit 5 as compared with the first embodiment, so that the circuit arrangement can be simplified.

In embodiments of this invention, the combination converted as mentioned above can be demodulated by a suitable demodulating circuit.

While in the above embodiments the case of $T_{max} = 4T'$ and $T_{max} = 5T'$ are described, the invention is not limited to the above cases, but can be applied to other combinations including a combination in which at least the DC component is controlled to be less than ±2, for example, a combination which can be controlled to be combined with a combination having zero DC component and whose DC component is fixed.

## Claims

1. A method of converting a digital signal into a non-return to zero, inverted-coded (NRZI-coded) signal, the method comprising the steps of:

a) dividing (2) a basic digital signal into a series of basic words, each word having m bits of data ($B_1$ to $B_8$);

b) converting (3) said basic words into converted words, each of said converted words having n bits of data ($P_1$ to $P_{10}$), wherein n is greater than m + 1, the series of converted words comprising a predetermined maximum number of consecutive digital zeroes;

c) said converted words comprising primary combinations of n bits having a DC component equal to zero when NRZI-coded, and pairs of secondary combinations of n bits having a DC component with a magnitude of two when NRZI-coded, the DC component of the combinations of each being of opposite polarity, and the pairs being chosen to differ only in the first bit of data ($P_1$) thereof;

d) generating (5, 20) a control signal in response to the digital sum variation (DSV') in the series of converted words preceding the respective word to be converted in response to the detection of a primary or a secondary combination, by forming (5) a first signal indicating if the number of digital zeroes in the respective word to be converted is even, and comparing (20e) said first signal with the preceding control signal (Q) for generating the respective control signal (Q);

e) selectively inverting (11) the first bit of data ($P_1$) of a secondary combination in response to said control signal; and

f) generating (10) from said converted words said NRZI-coded signal.

2. A method of converting a digital signal into a non-return to zero, inverted-coded (NRZI-coded) signal, the method comparing the steps of:

a) dividing (2) a basic digital signal into a series of basic words, each word having m bits of data ($B_1$ to $B_8$);

b) converting (3) said basic words into converted words, each of said converted words having n bits of data ($P_1$ to $P_{10}$), wherein n is greater than m + 1, the series of converted words comprising a predetermined maximum number of consecutive digital zeroes;

c) said converted words comprising primary pairs of combinations of n bits having a DC component equal to zero when NRZI-coded, and pairs of secondary combinations of n bits having a DC component with a magnitude of two when NRZI-coded, the DC component of the combinations of each being of opposite polarity, and the primary and secondary combinations of each pair being chosen to differ only in the first bit of data ($P_1$) thereof;

d) generating (20) a control signal in response to the digital sum variation (DSV') in the series of converted words preceding the respective word to be converted, by forming (20a to 20d) a first signal indicating if the number of digital zeroes in the respective word to be converted is even, and comparing (20f) said first signal with the preceding control signal (Q) for generating the respective control signal (Q);

e) selectively inverting (11) the first bit of data ($P_1$) of a secondary combination in response to said control signal (Q); and

f) generating (10) from said converted words said NRZI-coded signal.

3. A method according to claim 1 or claim 2 wherein m is eight and n is ten.

4. Apparatus for converting a digital signal into a non-return to zero, inverted-coded (NRZI-coded) signal, the method comprising the steps of:

a) means (2) for dividing a basic digital signal into a series of basic words, each word having m bits of data ($B_1$ to $B_8$);

b) means (3) for converting said basic words into converted words, each of said converted words having n bits of data ($P_1$ to $P_{10}$), wherein n is greater than m + 1, the series of converted words comprising a predetermined maximum number of consecutive digital zeroes;

c) said converted words comprising primary combinations of n bits having a DC component equal to zero when NRZI-coded, and pairs of secondary combinations of n bits having a DC component with a magnitude of two when NRZI-coded, the DC component of the combinations of each being of opposite polarity, and pairs being chosen to differ only in the first bit of data ($P_1$) thereof;

d) means (5, 20) for generating a control signal in response to the digital sum variation (DSV') in the series of converted words preceding the respective word to be converted to the detection of a primary or a a secondary combination, by forming (5) a first signal indicating if the number of digital zeroes in the respective word to be converted is even, and comparing (20e) said first signal with the preceding control signal (Q) for generating the respective control signal (Q);

e) means (11) for selectively inverting the first bit of data ($P_1$) of a secondary combination in response to said control signal; and

f) means (10) for generating from said converted words said NRZI-coded signal.

5. Apparatus for converting a digital signal into a non-return to zero, inverted-coded (NRZI-coded) signal, the method comparing the steps of:

a) means (2) for dividing a basic digital signal into a series of basic words, each word having m bits of data ($B_1$ to $B_8$);

b) means (3) for converting said basic words into converted words, each of said converted words having n bits of data ($P_1$ to $P_{10}$), wherein n is greater than m + 1, the series of converted words comprising a predetermined maximum number of consecutive digital zeroes;

c) said converted words comprising primary pairs of combinations of n bits having a DC component equal to zero when NRZI-coded, and pairs of secondary combinations of n bits having a DC component with a magnitude of two when NRZI-coded, the DC component of the secondary combinations of each pair being of opposite polarity, and the primary and secondary combinations of each pair being chosen to differ only in the first bit of data ($P_1$) thereof;

d) means (20) for generating a control signal in response to the digital sum variation (DSV') in the series of converted words preceding the respective word to be converted, by forming (20a to 20d) a first signal indicating if the number of digital zeroes in the respective word to be converted is even, and comparing (20f) said first signal with the preceding control signal (Q) for generating the respective control signal (Q);

e) means (11) for selectively inverting the first bit of data ($P_1$) of a secondary combination in response to said control signal (Q); and

f) means (10) for generating from said converted words said NRZI-coded signal.

6. Apparatus according to claim 4 wherein said means (5, 20) for generating comprises logic means (5) for generating said first signal in response to a parity of said digital value in each odd-numbered bit of said converted word and a memory circuit (20f) for holding said first signal during every cycle.

7. Apparatus according to claim 6 wherein said logic means (5) includes an exclusive-OR circuit and said memory circuit (20f) includes a flip-flop circuit (20f).

8. Apparatus according to any one of claims 4 to 7 wherein m is eight and n is ten.

11

**Patentansprüche**

1. Verfahren zur Umwandlung eines digitalen Signals in ein nicht auf Null zurückkehrendes invertiert kodiertes Signal (NRZI-kodiertes Signal) mit den Verfahrensschritten:

(a) Teilen (2) eines digitalen Basissignals in eine Reihe von Basiswörtern mit jeweils m Datenbits ($B_1$ bis $B_8$),

(b) Konvertieren (3) der Basiswörter in Wörter mit jeweils n Datenbits ($P_1$ bis $P_{10}$), wobei n größer ist als m + 1 und wobei die Reihe von konvertierten Wörtern eine vorbestimmte maximale Anzahl von aufeinanderfolgenden digitalen Nullen aufweist,

(c) wobei diese konvertierten Wörter Primärkombinationen von n Bits mit einer Gleichstrom-Komponente umfassen, die gleich Null ist, wenn sie NRZI-kodiert sind, sowie Paare von Sekundärkombinationen von n Bits mit einer Gleichstrom-Komponente mit der Größe zwei, wenn sie NRZI-kodiert sind, wobei die Gleichstrom-Komponente der Kombinationen jedes Paares entgegengesetzte Polarität hat und die Paare so gewählt sind, daß sie sich nur in ihrem ersten Datenbit ($P_1$) unterscheiden,

(d) Erzeugen (5, 20) eines Steuersignals in Abhängigkeit von der Änderung der digitalen Summe (DSV') in der Reihe von konvertierten Wörtern, die dem betreffenden zu konvertierenden Wort vorangehen, und in Abhängigkeit von der Erfassung einer Primärkombination oder einer Sekundärkombination durch Bilden (5) eines ersten Signals, das angibt, wenn die Zahl von digitalen Nullen in dem betreffenden zu konvertierenden Wort geradzahlig ist, und Vergleichen (20e) des ersten Signals mit dem vorhergehenden Steuersignal (Q) zum Erzeugen des betreffenden Steuersignals (Q),

(e) selektives Invertieren (11) des ersten Datenbits ($P_1$) einer Sekundärkombination in Abhängigkeit von dem Steuersignal und

(f) Erzeugen (10) des NRZI-kodierten Signals aus den konvertierten Wörtern.

2. Verfahren zur Umwandlung eines digitalen Signals in ein nicht auf Null zurückkehrendes invertiert kodiertes Signal (NRZI-kodiertes Signal) mit den Verfahrensschritten:

(a) Teilen (2) eines digitalen Basissignals in eine Reihe von Basiswörtern mit jeweils m Datenbits ($B_1$ bis $B_8$),

(b) Konvertierden (3) der Basiswörter in Wörter mit jeweils n Datenbits ($P_1$ bis $P_{10}$), wobei n größer ist als m + 1 und wobei die Reihe von konvertierten Wörtern eine vorbestimmte maximale Anzahl von aufeinanderfolgenden digitalen Nullen aufweist,

(c) wobei diese konvertierten Wörter primäre Paare von Kombinationen von n Bits mit einer Gleichstrom-Komponente umfassen, die gleich Null ist, wenn sie NRZI-kodiert sind, sowie Paare von Sekundärkombinationen von n Bits mit einer Gleichstrom-Komponente mit der Größe zwei, wenn sie NRZI-kodiert sind, wobei die Gleichstrom-Komponente der Sekundärkombinationen jedes Paares entgegengesetzte Polarität hat und die Primärkombinationen und die Sekundärkombinationen jedes Paares so gewählt sind, daß sie sich nur in ihrem ersten Datenbit ($P_1$) unterscheiden,

(d) Erzeugen (5, 20) eines Steuersignals in Abhängigkeit von der Änderung der digitalen Summe (DSV') in der Reihe von konvertierten Wörtern, die dem betreffenden zu konvertierenden Wort vorangehen, und in Abhängigkeit von der Erfassung einer Primärkombination oder einer Sekundärkombination durch Bilden (5) eines ersten Signals, das anzeigt, wenn die Zahl von digitalen Nullen in dem betreffenden zu konvertierenden Wort geradzahlig ist, und Vergleichen (20f) des ersten Signals mit dem vorhergehenden Steuersignal (Q) zum Erzeugen des betreffenden Steuersignals (Q),

(e) selektives Invertieren (11) des ersten Datenbits ($P_1$) einer Sekundärkombination als Reaktion auf das Steuersignal (Q) und

(f) Erzeugen (10) des NRZI-kodierten Signals aus den konvertierten Wörtern.

3. Verfahren nach Anspruch 1 oder 2, bei dem m gleich 8 und n gleich 10 ist.

4. Vorrichtung zur Umwandlung eines digitalen Signals in ein nicht auf Null zurückkehrendes invertiert kodiertes Signal (NRZI-kodiertes Signal), welche aufweist:

(a) Mittel (2) zum Teilen eines digitalen Basissignals in eine Reihe von Basiswörtern mit jeweils m Datenbits ($B_1$ bis $B_8$),

(b) Mittel (3) zum Konvertieren der Basiswörter in Wörter mit jeweils n Datenbits ($P_1$ bis $P_{10}$), wobei n größer ist als m + 1 und wobei die Reihe von konvertierten Wörtern eine vorbestimmte maximale Anzahl von aufeinanderfolgenden digitalen Nullen aufweist,

(c) wobei diese konvertierten Wörter Primärkombinationen von n Bits mit einer Gleichstrom-Komponente umfassen, die gleich Null ist, wenn sie NRZI-kodiert sind, sowie Paare von Sekundärkombinationen von n Bits mit einer Gleichstrom-Komponente mit der Größe zwei, wenn sie NRZI-kodiert sind, wobei die Gleichstrom-Komponente der Kombinationen jedes Paares entgegengesetzte Polarität hat und die Paare so gewählt sind, daß sie sich nur in ihrem ersten Datenbit ($P_1$) unterscheiden,

(d) Mittel (5, 20) zum Erzeugen eines Steuersignals in Abhängigkeit von der Änderung der digitalen Summe (DSV') in der Reihe von konvertierten Wörtern, die dem betreffenden zu konvertierenden Wort vorangehen, und in Abhängigkeit von der Erfassung einer Primärkombination oder einer Sekundärkombination durch Bilden (5) eines ersten Signals, das anzeigt, wenn die Zahl von digitalen Nullen in dem betreffenden zu konvertierenden Wort geradzahlig ist, und Vergleichen (20e) des ersten Signals mit dem vorhergehenden Steuersignal (Q) zum Erzeugen des betreffenden Steuersignals (Q),

12

(e) Mittel (11) zum selektiven Invertieren des ersten Datenbits ($P_1$) einer Sekundärkombination als Reaktion auf das Steuersignal und

(f) Mittel (10) zum Erzeugen des NRZI-kodierten Signals aus den konvertierten Wörtern.

5. Vorrichtung zur Umwandlung eines digitalen Signals in ein nicht auf Null zurückkehrendes invertiert kodiertes Signal (NRZI-kodiertes Signal), welche aufweist:

(a) Mittel (2) zum Teilen (2) eines digitalen Basissignals in eine Reihe von Basiswörtern mit jeweils m Datenbits ($B_1$ bis $B_8$),

(b) Mittel (3) zum Konvertieren der Basiswörter in Wörter mit jeweils n Datenbits ($P_1$ bis $P_{10}$), wobei n größer ist als m + 1 und wobei die Reihe von konvertierten Wörtern eine vorbestimmte maximale Anzahl von aufeinanderfolgenden digitalen Nullen aufweist,

(c) wobei diese konvertierten Wörter primäre Paare von Kombinationen von n Bits mit einer Gleichstrom-Komponente umfassen, die gleiche Null ist, wenn sie NRZI-kodiert sind, sowie Paare von Sekundärkombinationen von n Bits mit einer Gleichstrom-Komponente mit der Größe zwei, wenn sie NRZI-kodiert sind, wobei die Gleichstrom-Komponente der Sekundärkombinationen jedes Paares entgegengesetztee Polarität hat und die Primärkombinationen und die Sekundärkombinationen jedes Paares gewählt sind, daß sie sich nur in ihrem ersten Datenbit ($P_1$) unterscheiden,

(d) Mittel (5, 20) zum Erzeugen eines Steuersignals in Abhängigkeit von der Änderung der digitalen Summe (DSV') in der Reihe von konvertierten Wörtern, die dem betreffenden zu konvertierenden Wort vorangehen, und in Abhängigkeit von der Erfassung einer Primärkombination oder einer Sekundärkombination durch Bilden (5) eines ersten Signals, das anzeigt, wenn die Zahl von digitalen Nullen in dem betreffenden zu konvertierenden Wort geradzahlig ist, und Vergleichen (20f) des ersten Signals mit dem vorhergehenden Steuersignal (Q) zum Erzeugen des betreffenden Steuersignals (Q),

(e) Mittel zum (11) selektiven Invertieren des ersten Datenbits ($P_1$) einer Sekundärkombination als Reaktion auf das Steuersignal (Q) und

(f) Mittel (10) zum Erzeugen des NRZI-kodierten Signals aus den konvertierten Wörtern.

6. Vorrichtung nach Anspruch 4, bei der die Mittel (5, 20) zum Erzeugen des Steuersignal logische Mittel (5) zur Erzeugung des ersten Signals in Abhängigkeit von einer Parität des digitalen Wert in jedem ungeradzahligen Bit des konvertierten Worts aufweisen sowie eine Speicherschaltung (20f) zum Halten des ersten Signals während jedes Konvertierungszyklus.

7. Vorrichtung nach Anspruch 6, bei der die logischen Mittel (5) eine Exklusiv-ODER-Glied und die Speicherschaltung (20f) ein Flipflop-Schaltung (20f) enthalten.

8. Vorrichtung nach einem der Ansprüche 4 bis 7, bei der m gleich 8 und g gleich 10 ist.

**Revendications**

1. Procédé de conversion d'un signal numérique en un signal codé à non retour à zéro et inversion (codé NRZI), le procédé étant caractérisé en ce qu'il comprend les étapes suivantes:

a) division (2) d'un signal numérique de base en une série de mots de base, chaque mot étant constitué par m bits de donnée ($B_1$ à $B_8$);

b) conversion (3) des mots de base en mots convertis, chacun des mots convertis étant constitué par n bits de donnée ($P_1$ à $P_{10}$), où n est plus grand que m + 1, les séries de mots convertis comprenant un nombre maximum prédéterminé de zéros numériques consécutifs;

c) ces mots convertis comprenant des combinaisons primaires de n bits qui comportent une composante continue égale à zéro lorsque le codage est NRZI, et des paires de combinaisons secondaires de n bits qui comportent une composante continue d'une grandeur de deux lorsque le codage est NRZI, la composante continue des combinaisons de chaque paire étant de polarité opposée, et les paires étant choisies de manière à se distinguer les unes des autres seulement par leur premier bit de donnée ($P_1$);

d) génération (5, 20) d'un signal de contrôle en réponse à l'écart de somme numérique (ESN') dans les séries de mots convertis qui précèdent précisément le mot qui doit être converti et en réponse à la détection d'une combinaison primaire ou d'une combinaison secondaire, par la formation (5) d'un premier signal qui indique si le nombre de zéros numériques dans le mot en question à convertir est pair, et comparaison (20e) du premier signal avec le signal de contrôle précédant (Q) afin de générer le signal de contrôle correspondant (Q);

e) inversion sélective (11) du premier bit de donnée ($P_1$) d'une combinaison secondaire en réponse au signal de contrôle; et

f) génération (10) à partir des mots convertis du signal codé NRZI.

2. Procédé de conversion d'un signal numérique en un signal codé à non retour à zéro et inversion (codé NRZI), le procédé étant caractérisé en ce qu'il comprend les étapes suivantes:

a) division (2) d'un signal numérique de base en une série de mots de base, chaque mot étant constitué de m bits de donnée ($B_1$ à $B_8$);

b) conversion (3) des mots de base en mots convertis, chacun des mots convertis étant constitué de n bits de donnée ($P_1$ à $P_{10}$), où n est plus grand que m + 1, les séries de mots convertis comprenant un nombre maximum prédéterminé de zéros numériques consécutifs;

c) ces mots convertis comprenant des paires de combinaisons primaires de n bits qui comportent une composante continue égale à zéro lorsque le codage est NRZI, et des paires de combinaisons secondaires

13

de n bits qui comportent une composante continue d'une grandeur de deux lorsque le codage est NRZI, la composante continue des combinaisons secondaires de chaque paire étant de polarité opposée, et les combinaisons primaire et secondaire de chaque paire étant choisies de manière à se distinguer les unes des autres seulement par leur premier bit de donnée ($P_1$);

d) génération (20) d'un signal de contrôle en réponse à l'écart de somme numérique (ESN') dans les séries de mots convertis qui précèdent précisément le mot qui doit être converti, par la formation (20a à 20d) d'un premier signal qui indique si le nombre de zéros numériques dans le mot en question à convertir est pair, et comparaison (20f) du premier signal avec le signal de contrôle précédant (Q) afin de générer le signal de contrôle correspondant (Q);

e) inversion sélective (11) du premier bit de donnée ($P_1$) d'une combinaison secondaire en réponse au signal de contrôle (Q); et

f) génération (10) à partir des mots convertis du signal codé NRZI.

3. Procédé selon les revendications 1 ou 2, caractérisé en ce que m est égal à huit et en ce que n est égal à dix.

4. Dispositif de conversion d'un signal numérique en un signal codé à non retour à zéro et inversion (codé NRZI), le procédé étant caractérisé en ce qu'il comprend les étapes suivantes:

a) un moyen (2) de division d'un signal numérique de base en une série de mots de base, chaque mot étant constitué par m bits de donnée ($B_1$ à $B_8$);

b) un moyen (3) de conversion des mots de base en mots convertis, chacun des mots convertis étant constitué par n bits de donnée ($P_1$ à $P_{10}$), où n est plus grand que m + 1, les séries de mots convertis comprenant un nombre maximum prédéterminé de zéros numériques consécutifs;

c) ces mots convertis comprenant des combinaisons primaires de n bits qui comportent une composante continue égale à zéro lorsque le codage est NRZI, et des paires de combinaisons secondaires de n bits qui comportent une composante continue d'une grandeur de deux lorsque le codage est NRZI, la composante continue des combinaisons de chaque paire étant de polarité opposée, et les paires étant choisies de manière à se distinguer les unes des autres seulement par leur premier bit de donnée ($P_1$);

d) un moyen (5, 20) génération d'un signal de contrôle en réponse à l'écart de somme numérique (ESN') dans les séries de mots convertis qui précèdent précisément le mot qui doit être converti et en réponse à la détection d'une combinaison primaire ou d'une combinaison secondaire, par la formation (5) d'un premier signal qui indique si le nombre de zéros numériques dans le mot en question à convertir est pair, et comparaison (20e) du premier signal avec le signal de contrôle précédant (Q) afin de générer le signal de contrôle correspondant (Q);

e) un moyen (11) d'inversion sélective (11) du premier bit de donnée ($P_1$) d'une combinaison secondaire en réponse au signal de contrôle; et

f) un moyen (10) de génération à partir des mots convertis du signal codé NRZI.

5. Dispositif de conversion d'un signal numérique en un signal codé à non retour à zéro et inversion (codé NRZI), le procédé étant caractérisé en ce qu'il comprend les étapes suivantes:

a) un moyen (2) de division d'un signal numérique de base en une série de mots de base, chaque mot étant constitué par m bits de donnée ($B_1$ à $B_8$);

b) un moyen (3) de conversion des mots de base en mots convertis, chacun des mots convertis étant constitué par n bits de donnée ($P_1$ à $P_{10}$), où n est plus grand que m + 1, les séries de mots convertis comprenant un nombre maximum prédéterminé de zéros numériques consécutifs;

c) ces mots convertis comprenant des paires de combinaisons primaires de n bits qui comportent une composante continue égale à zéro lorsque le codage est NRZI, et des paires de combinaisons secondaires de n bits qui comportent une composante continue d'une grandeur de deux lorsque le codage est NRZI, la composante continue des combinaisons secondaires de chaque paire étant de polarité opposée, et les combinaisons primaire et secondaire de chaque paire étant choisies de manière à se distinguer les unes des autres seulement par leur premier bit de donnée ($P_1$);

d) moyens (20) de génération d'un signal de contrôle en réponse à l'écart de somme numérique (ESN') dans les séries de mots convertis qui précèdent précisément le mot qui doit être converti, par la formation (20a à 20d) d'un premier signal qui indique si le nombre de zéros numériques dans le mot en question à convertir est pair, et comparaison (20f) du premier signal avec le signal de contrôle précédant (Q) afin de générer le signal de contrôle correspondant (Q);

e) moyen (11) d'inversion sélective du premier bit de donnée ($P_1$) d'une combinaison secondaire en réponse au signal de contrôle (Q); et

f) moyen (10) de génération à partir des mots convertis du signal codé NRZI.

6. Dispositif selon la revendication 4, caractérisé en ce que le moyen (5, 20) de générations comporte un moyen logique (5) permettant de générer le premier signal en réponse à une partie de la veleur numérique dans chaque bit d'ordre impair du mot converti anisi qu'un circuit de mémorisation (20f) permettant de mémoriser le premier signal pendant chaque cycle de conversion.

7. Dispositif selon la revendication 6, caractérisé en ce que le moyen logique (5) comporte un circuit OU exclusif et en ce que le circuit de mémorisation (20f) comporte un bascule (20f).

8. Dispositif selon l'une quelconque des revendications 4 à 7, caractérisé en ce que m est égal à huit et en ce que n est égal à dix.

*F I G. 1A*

*F I G. 1B*

*F I G. 1C*

*F I G. 2A*

*F I G. 2B*

FIG. 3A

FIG. 3B

*F I G.  4A*

*F I G.  4B*

# F I G. 5

# FIG. 6A

| No. | Q' = -1 CODE | DC | DSV | DV | P | Q | Q' = 1 CODE | DC | DSV | DV | P | Q |
|---|---|---|---|---|---|---|---|---|---|---|---|---|
| 1 | 1100100010 | 0 | 3 | 21 | 0 | -1 | 0100100010 | 0 | 3 | 21 | 1 | -1 |
| 2 | 1101110111 | 0 | 2 | 13 | 0 | -1 | 0101110111 | 0 | 2 | 13 | 1 | -1 |
| 3 | 1101110010 | 0 | 2 | 13 | 0 | -1 | 0101110010 | 0 | 2 | 13 | 1 | -1 |
| 4 | 1101010101 | 0 | 2 | 13 | 0 | -1 | 0101010101 | 0 | 2 | 13 | 1 | -1 |
| 5 | 1101011101 | 0 | 2 | 13 | 1 | 1 | 0101011101 | 0 | 2 | 13 | 0 | 1 |
| 6 | 1101011111 | 0 | 2 | 9 | 0 | -1 | 0101011111 | 0 | 2 | 9 | 1 | -1 |
| 7 | 1101011010 | 0 | 2 | 9 | 0 | -1 | 0101011010 | 0 | 2 | 9 | 1 | -1 |
| 8 | 1101001001 | 0 | 2 | 13 | 1 | 1 | 0101001001 | 0 | 2 | 13 | 0 | 1 |
| 9 | 1101001011 | 0 | 2 | 9 | 0 | -1 | 0101001011 | 0 | 2 | 9 | 1 | -1 |
| 10 | 1101001110 | 0 | 2 | 9 | 0 | -1 | 0101001110 | 0 | 2 | 9 | 1 | -1 |
| 11 | 1101000100 | 0 | 2 | 13 | 0 | -1 | 0101000100 | 0 | 2 | 13 | 1 | -1 |
| 12 | 1111011101 | 0 | 2 | 13 | 0 | -1 | 0111011101 | 0 | 2 | 13 | 1 | -1 |
| 13 | 1111010101 | 0 | 2 | 13 | 1 | 1 | 0111010101 | 0 | 2 | 13 | 0 | 1 |
| 14 | 1111010111 | 0 | 2 | 9 | 0 | -1 | 0111010111 | 0 | 2 | 9 | 1 | -1 |
| 15 | 1111010010 | 0 | 2 | 9 | 0 | -1 | 0111010010 | 0 | 2 | 9 | 1 | -1 |
| 16 | 1111110111 | 0 | 2 | 13 | 1 | 1 | 0111110111 | 0 | 2 | 13 | 0 | 1 |
| 17 | 1111110101 | 0 | 2 | 9 | 0 | -1 | 0111110101 | 0 | 2 | 9 | 1 | -1 |
| 18 | 1111111101 | 0 | 2 | 9 | 1 | 1 | 0111111101 | 0 | 2 | 9 | 0 | 1 |
| 19 | 1111111111 | 0 | 1 | 5 | 0 | -1 | 0111111111 | 0 | 1 | 5 | 1 | -1 |
| 20 | 1111111010 | 0 | 1 | 5 | 0 | -1 | 0111111010 | 0 | 1 | 5 | 1 | -1 |
| 21 | 1111101001 | 0 | 2 | 9 | 1 | 1 | 0111101001 | 0 | 2 | 9 | 0 | 1 |
| 22 | 1111101011 | 0 | 1 | 5 | 0 | -1 | 0111101011 | 0 | 1 | 5 | 1 | -1 |
| 23 | 1111101110 | 0 | 1 | 5 | 0 | -1 | 0111101110 | 0 | 1 | 5 | 1 | -1 |
| 24 | 1111100100 | 0 | 2 | 9 | 0 | -1 | 0111100100 | 0 | 2 | 9 | 1 | -1 |
| 25 | 1110100010 | 0 | 3 | 21 | 1 | 1 | 0110100010 | 0 | 3 | 21 | 0 | 1 |
| 26 | 1110100111 | 0 | 2 | 13 | 1 | 1 | 0110100111 | 0 | 2 | 13 | 0 | 1 |
| 27 | 1110100101 | 0 | 2 | 9 | 0 | -1 | 0110100101 | 0 | 2 | 9 | 1 | -1 |
| 28 | 1110101101 | 0 | 2 | 9 | 1 | 1 | 0110101101 | 0 | 2 | 9 | 0 | 1 |
| 29 | 1110101111 | 0 | 1 | 5 | 0 | -1 | 0110101111 | 0 | 1 | 5 | 1 | -1 |
| 30 | 1110101010 | 0 | 1 | 5 | 0 | -1 | 0110101010 | 0 | 1 | 5 | 1 | -1 |
| 31 | 1110111001 | 0 | 2 | 9 | 1 | 1 | 0110111001 | 0 | 2 | 9 | 0 | 1 |
| 32 | 1110111011 | 0 | 1 | 5 | 0 | -1 | 0110111011 | 0 | 1 | 5 | 1 | -1 |
| 33 | 1110111110 | 0 | 1 | 5 | 0 | -1 | 0110111110 | 0 | 1 | 5 | 1 | -1 |
| 34 | 1110110100 | 0 | 2 | 9 | 0 | -1 | 0110110100 | 0 | 2 | 9 | 1 | -1 |
| 35 | 1110010001 | 0 | 2 | 13 | 1 | 1 | 0110010001 | 0 | 2 | 13 | 0 | 1 |
| 36 | 1110010011 | 0 | 2 | 9 | 0 | -1 | 0110010011 | 0 | 2 | 9 | 1 | -1 |
| 37 | 1110010110 | 0 | 2 | 9 | 0 | -1 | 0110010110 | 0 | 2 | 9 | 1 | -1 |
| 38 | 1110011100 | 0 | 2 | 13 | 0 | -1 | 0110011100 | 0 | 2 | 13 | 1 | -1 |
| 39 | 0100011100 | 0 | 2 | 17 | 0 | -1 | 1100011100 | 0 | 2 | 17 | 1 | -1 |
| 40 | 0100010110 | 0 | 2 | 13 | 0 | -1 | 1100010110 | 0 | 2 | 13 | 1 | -1 |
| 41 | 0100010011 | 0 | 2 | 13 | 0 | -1 | 1100010011 | 0 | 2 | 13 | 1 | -1 |
| 42 | 0100010001 | 0 | 2 | 17 | 1 | 1 | 1100010001 | 0 | 2 | 17 | 0 | 1 |
| 43 | 0100110100 | 0 | 2 | 13 | 0 | -1 | 1100110100 | 0 | 2 | 13 | 1 | -1 |
| 44 | 0100111110 | 0 | 2 | 9 | 0 | -1 | 1100111110 | 0 | 2 | 9 | 1 | -1 |
| 45 | 0100111011 | 0 | 2 | 9 | 0 | -1 | 1100111011 | 0 | 2 | 9 | 1 | -1 |
| 46 | 0100111001 | 0 | 2 | 13 | 1 | 1 | 1100111001 | 0 | 2 | 13 | 0 | 1 |
| 47 | 0100101010 | 0 | 2 | 9 | 0 | -1 | 1100101010 | 0 | 2 | 9 | 1 | -1 |
| 48 | 0100101111 | 0 | 2 | 9 | 0 | -1 | 1100101111 | 0 | 2 | 9 | 1 | -1 |
| 49 | 0100101101 | 0 | 2 | 13 | 1 | 1 | 1100101101 | 0 | 2 | 13 | 0 | 1 |
| 50 | 0100100101 | 0 | 2 | 13 | 0 | -1 | 1100100101 | 0 | 2 | 13 | 1 | -1 |
| 51 | 0100100111 | 0 | 2 | 17 | 1 | 1 | 1100100111 | 0 | 2 | 17 | 0 | 1 |
| 52 | 0101100100 | 0 | 2 | 13 | 0 | -1 | 1101100100 | 0 | 2 | 13 | 1 | -1 |
| 53 | 0101101110 | 0 | 2 | 9 | 0 | -1 | 1101101110 | 0 | 2 | 9 | 1 | -1 |
| 54 | 0101101011 | 0 | 2 | 9 | 0 | -1 | 1101101011 | 0 | 2 | 9 | 1 | -1 |

## F I G. 6B

| | | | | | | | | | | | | |
|---|---|---|---|---|---|---|---|---|---|---|---|---|
| 55 | 0101101001 | 0 | 2 | 13 | 1 | 1 | 1101101001 | 0 | 2 | 13 | 0 | 1 |
| 56 | 0101111010 | 0 | 2 | 9 | 0 | -1 | 1101111010 | 0 | 2 | 9 | 1 | -1 |
| 57 | 0101111111 | 0 | 2 | 9 | 0 | -1 | 1101111111 | 0 | 2 | 9 | 1 | -1 |
| 58 | 0101111101 | 0 | 2 | 13 | 1 | 1 | 1101111101 | 0 | 2 | 13 | 0 | 1 |
| 59 | 0101110101 | 0 | 2 | 13 | 0 | -1 | 1101110101 | 0 | 2 | 13 | 1 | -1 |
| 60 | 0101010010 | 0 | 2 | 13 | 0 | -1 | 1101010010 | 0 | 2 | 13 | 1 | -1 |
| 61 | 0101010111 | 0 | 2 | 13 | 0 | -1 | 1101010111 | 0 | 2 | 13 | 1 | -1 |
| 62 | 0111000100 | 0 | 2 | 17 | 0 | -1 | 1111000100 | 0 | 2 | 17 | 1 | -1 |
| 63 | 0111001110 | 0 | 2 | 13 | 0 | -1 | 1111001110 | 0 | 2 | 13 | 1 | -1 |
| 64 | 0111001011 | 0 | 2 | 13 | 0 | -1 | 1111001011 | 0 | 2 | 13 | 1 | -1 |
| 65 | 0111001001 | 0 | 2 | 17 | 1 | 1 | 1111001001 | 0 | 2 | 17 | 0 | 1 |
| 66 | 0111011010 | 0 | 2 | 13 | 0 | -1 | 1111011010 | 0 | 2 | 13 | 1 | -1 |
| 67 | 0111011111 | 0 | 2 | 13 | 0 | -1 | 1111011111 | 0 | 2 | 13 | 1 | -1 |
| 68 | 0111110010 | 0 | 2 | 17 | 0 | -1 | 1111110010 | 0 | 2 | 17 | 1 | -1 |
| 69 | 1010001001 | 0 | 3 | 21 | 0 | -1 | 0010001001 | 0 | 3 | 21 | 1 | -1 |
| 70 | 1010011111 | 0 | 2 | 17 | 1 | 1 | 0010011111 | 0 | 2 | 17 | 0 | 1 |
| 71 | 1010011101 | 0 | 2 | 13 | 0 | -1 | 0010011101 | 0 | 2 | 13 | 1 | -1 |
| 72 | 1010010101 | 0 | 2 | 13 | 1 | 1 | 0010010101 | 0 | 2 | 13 | 0 | 1 |
| 73 | 1010010111 | 0 | 2 | 9 | 0 | -1 | 0010010111 | 0 | 2 | 9 | 1 | -1 |
| 74 | 1010010010 | 0 | 2 | 9 | 0 | -1 | 0010010010 | 0 | 2 | 9 | 1 | -1 |
| 75 | 1010110010 | 0 | 3 | 21 | 1 | 1 | 0010110010 | 0 | 3 | 21 | 0 | 1 |
| 76 | 1010110111 | 0 | 2 | 13 | 1 | 1 | 0010110111 | 0 | 2 | 13 | 0 | 1 |
| 77 | 1010110101 | 0 | 2 | 9 | 0 | -1 | 0010110101 | 0 | 2 | 9 | 1 | -1 |
| 78 | 1010111101 | 0 | 2 | 9 | 1 | 1 | 0010111101 | 0 | 2 | 9 | 0 | 1 |
| 79 | 1010111111 | 0 | 1 | 5 | 0 | -1 | 0010111111 | 0 | 1 | 5 | 1 | -1 |
| 80 | 1010111010 | 0 | 1 | 5 | 0 | -1 | 0010111010 | 0 | 1 | 5 | 1 | -1 |
| 81 | 1010101001 | 0 | 2 | 9 | 1 | 1 | 0010101001 | 0 | 2 | 9 | 0 | 1 |
| 82 | 1010101011 | 0 | 1 | 5 | 0 | -1 | 0010101011 | 0 | 1 | 5 | 1 | -1 |
| 83 | 1010101110 | 0 | 1 | 5 | 0 | -1 | 0010101110 | 0 | 1 | 5 | 1 | -1 |
| 84 | 1010100100 | 0 | 2 | 9 | 0 | -1 | 0010100100 | 0 | 2 | 9 | 1 | -1 |
| 85 | 1011100010 | 0 | 3 | 21 | 1 | 1 | 0011100010 | 0 | 3 | 21 | 0 | 1 |
| 86 | 1011100111 | 0 | 2 | 13 | 1 | 1 | 0011100111 | 0 | 2 | 13 | 0 | 1 |
| 87 | 1011100101 | 0 | 2 | 9 | 0 | -1 | 0011100101 | 0 | 2 | 9 | 1 | -1 |
| 88 | 1011101101 | 0 | 2 | 9 | 1 | 1 | 0011101101 | 0 | 2 | 9 | 0 | 1 |
| 89 | 1011101111 | 0 | 1 | 5 | 0 | -1 | 0011101111 | 0 | 1 | 5 | 1 | -1 |
| 90 | 1011101010 | 0 | 1 | 5 | 0 | -1 | 0011101010 | 0 | 1 | 5 | 1 | -1 |
| 91 | 1011111001 | 0 | 2 | 9 | 1 | 1 | 0011111001 | 0 | 2 | 9 | 0 | 1 |
| 92 | 1011111011 | 0 | 1 | 5 | 0 | -1 | 0011111011 | 0 | 1 | 5 | 1 | -1 |
| 93 | 1011111110 | 0 | 1 | 5 | 0 | -1 | 0011111110 | 0 | 1 | 5 | 1 | -1 |
| 94 | 1011110100 | 0 | 2 | 9 | 0 | -1 | 0011110100 | 0 | 2 | 9 | 1 | -1 |
| 95 | 1011010001 | 0 | 2 | 13 | 1 | 1 | 0011010001 | 0 | 2 | 13 | 0 | 1 |
| 96 | 1011010011 | 0 | 2 | 9 | 0 | -1 | 0011010011 | 0 | 2 | 9 | 1 | -1 |
| 97 | 1011010110 | 0 | 2 | 9 | 0 | -1 | 0011010110 | 0 | 2 | 9 | 1 | -1 |
| 98 | 1011011100 | 0 | 2 | 13 | 0 | -1 | 0011011100 | 0 | 2 | 13 | 1 | -1 |
| 99 | 0010000100 | 0 | 3 | 25 | 0 | -1 | 1010000100 | 0 | 3 | 25 | 1 | -1 |
| 100 | 0010001110 | 0 | 3 | 21 | 0 | -1 | 1010001110 | 0 | 3 | 21 | 1 | -1 |
| 101 | 0010001011 | 0 | 3 | 21 | 0 | -1 | 1010001011 | 0 | 3 | 21 | 1 | -1 |
| 102 | 0010011010 | 0 | 3 | 21 | 0 | -1 | 1010011010 | 0 | 3 | 21 | 1 | -1 |
| 103 | 1100101100 | 2 | 3 | 25 | 1 | -1 | 0100101100 | -2 | 3 | 25 | 0 | -1 |
| 104 | 1100100110 | 2 | 3 | 21 | 1 | -1 | 0100100110 | -2 | 3 | 21 | 0 | -1 |
| 105 | 1100100011 | 2 | 3 | 21 | 1 | -1 | 0100100011 | -2 | 3 | 21 | 0 | -1 |
| 106 | 1100100001 | 2 | 3 | 25 | 0 | 1 | 0100100001 | -2 | 3 | 25 | 1 | 1 |
| 107 | 1101111100 | 2 | 2 | 17 | 1 | -1 | 0101111100 | -2 | 2 | 17 | 0 | -1 |
| 108 | 1101110110 | 2 | 2 | 13 | 1 | -1 | 0101110110 | -2 | 2 | 13 | 0 | -1 |
| 109 | 1101110011 | 2 | 2 | 13 | 1 | -1 | 0101110011 | -2 | 2 | 13 | 0 | -1 |
| 110 | 1101110001 | 2 | 2 | 17 | 0 | 1 | 0101110001 | -2 | 2 | 17 | 1 | 1 |

# FIG. 6C

```
111  1101010100  2  2  13  1  -1   0101010100  -2  2  13  0  -1
112  1101011110  2  2   9  1  -1   0101011110  -2  2   9  0  -1
113  1101011011  2  2   9  1  -1   0101011011  -2  2   9  0  -1
114  1101011001  2  2  13  0   1   0101011001  -2  2  13  1   1
115  1101001010  2  2   9  1  -1   0101001010  -2  2   9  0  -1
116  1101001111  2  2   9  1  -1   0101001111  -2  2   9  0  -1
117  1101001101  2  2  13  0   1   0101001101  -2  2  13  1   1
118  1101000101  2  2  13  1  -1   0101000101  -2  2  13  0  -1
119  1101000111  2  2  17  0   1   0101000111  -2  2  17  1   1
120  1101000010  2  3  25  0   1   0101000010  -2  3  25  1   1
121  1111011100  2  2  13  1  -1   0111011100  -2  2  13  0  -1
122  1111010110  2  2   9  1  -1   0111010110  -2  2   9  0  -1
123  1111010011  2  2   9  1  -1   0111010011  -2  2   9  0  -1
124  1111010001  2  2  13  0   1   0111010001  -2  2  13  1   1
125  1111110100  2  2   9  1  -1   0111110100  -2  2   9  0  -1
126  1111111110  2  1   5  1  -1   0111111110  -2  1   5  0  -1
127  1111111011  2  1   5  1  -1   0111111011  -2  1   5  0  -1
128  1111111001  2  2   9  0   1   0111111001  -2  2   9  1   1
129  1111101010  2  1   5  1  -1   0111101010  -2  1   5  0  -1
130  1111101111  2  1   5  1  -1   0111101111  -2  1   5  0  -1
131  1111101101  2  2   9  0   1   0111101101  -2  2   9  1   1
132  1111100101  2  2   9  1  -1   0111100101  -2  2   9  0  -1
133  1111100111  2  2  13  0   1   0111100111  -2  2  13  1   1
134  1111100010  2  3  21  0   1   0111100010  -2  3  21  1   1
135  1110100100  2  2   9  1  -1   0110100100  -2  2   9  0  -1
136  1110101110  2  1   5  1  -1   0110101110  -2  1   5  0  -1
137  1110101011  2  1   5  1  -1   0110101011  -2  1   5  0  -1
138  1110101001  2  2   9  0   1   0110101001  -2  2   9  1   1
139  1110111010  2  1   5  1  -1   0110111010  -2  1   5  0  -1
140  1110111111  2  1   5  1  -1   0110111111  -2  1   5  0  -1
141  1110111101  2  2   9  0   1   0110111101  -2  2   9  1   1
142  1110110101  2  2   9  1  -1   0110110101  -2  2   9  0  -1
143  1110110111  2  2  13  0   1   0110110111  -2  2  13  1   1
144  1110110010  2  3  21  0   1   0110110010  -2  3  21  1   1
145  1110010010  2  2   9  1  -1   0110010010  -2  2   9  0  -1
146  1110010111  2  2   9  1  -1   0110010111  -2  2   9  0  -1
147  1110010101  2  2  13  0   1   0110010101  -2  2  13  1   1
148  1110011101  2  2  13  1  -1   0110011101  -2  2  13  0  -1
149  1110011111  2  2  17  0   1   0110011111  -2  2  17  1   1
150  1110011010  2  3  25  0   1   0110011010  -2  3  25  1   1
151  1110001001  2  3  21  1  -1   0110001001  -2  3  21  0  -1
152  1110001011  2  3  25  0   1   0110001011  -2  3  25  1   1
153  1110001110  2  3  33  0   1   0110001110  -2  3  33  1   1
154  1110000100  2  4  45  0   1   0110000100  -2  4  45  1   1
155  1010011100  2  2  13  1  -1   0010011100  -2  2  13  0  -1
156  1010010110  2  2   9  1  -1   0010010110  -2  2   9  0  -1
157  1010010011  2  2   9  1  -1   0010010011  -2  2   9  0  -1
158  1010010001  2  2  13  0   1   0010010001  -2  2  13  1   1
159  1010110100  2  2   9  1  -1   0010110100  -2  2   9  0  -1
160  1010111110  2  1   5  1  -1   0010111110  -2  1   5  0  -1
161  1010111011  2  1   5  1  -1   0010111011  -2  1   5  0  -1
162  1010111001  2  2   9  0   1   0010111001  -2  2   9  1   1
163  1010101010  2  1   5  1  -1   0010101010  -2  1   5  0  -1
164  1010101111  2  1   5  1  -1   0010101111  -2  1   5  0  -1
165  1010101101  2  2   9  0   1   0010101101  -2  2   9  1   1
166  1010100101  2  2   9  1  -1   0010100101  -2  2   9  0  -1
```

# FIG. 6D

| 167 | 1010100111 | 2 | 2 | 13 | 0 | 1 | 0010100111 | -2 | 2 | 13 | 1 | 1 |
|---|---|---|---|---|---|---|---|---|---|---|---|---|
| 168 | 1010100010 | 2 | 3 | 21 | 0 | 1 | 0010100010 | -2 | 3 | 21 | 1 | 1 |
| 169 | 1011100100 | 2 | 2 | 9 | 1 | -1 | 0011100100 | -2 | 2 | 9 | 0 | -1 |
| 170 | 1011101110 | 2 | 1 | 5 | 1 | -1 | 0011101110 | -2 | 1 | 5 | 0 | -1 |
| 171 | 1011101011 | 2 | 1 | 5 | 1 | -1 | 0011101011 | -2 | 1 | 5 | 0 | -1 |
| 172 | 1011101001 | 2 | 2 | 9 | 0 | 1 | 0011101001 | -2 | 2 | 9 | 1 | 1 |
| 173 | 1011111010 | 2 | 1 | 5 | 1 | -1 | 0011111010 | -2 | 1 | 5 | 0 | -1 |
| 174 | 1011111111 | 2 | 1 | 5 | 1 | -1 | 0011111111 | -2 | 1 | 5 | 0 | -1 |
| 175 | 1011111101 | 2 | 2 | 9 | 0 | 1 | 0011111101 | -2 | 2 | 9 | 1 | 1 |
| 176 | 1011110101 | 2 | 2 | 9 | 1 | -1 | 0011110101 | -2 | 2 | 9 | 0 | -1 |
| 177 | 1011110111 | 2 | 2 | 13 | 0 | 1 | 0011110111 | -2 | 2 | 13 | 1 | 1 |
| 178 | 1011110010 | 2 | 3 | 21 | 0 | 1 | 0011110010 | -2 | 3 | 21 | 1 | 1 |
| 179 | 1011010010 | 2 | 2 | 9 | 1 | -1 | 0011010010 | -2 | 2 | 9 | 0 | -1 |
| 180 | 1011010111 | 2 | 2 | 9 | 1 | -1 | 0011010111 | -2 | 2 | 9 | 0 | -1 |
| 181 | 1011010101 | 2 | 2 | 13 | 0 | 1 | 0011010101 | -2 | 2 | 13 | 1 | 1 |
| 182 | 1011011101 | 2 | 2 | 13 | 1 | -1 | 0011011101 | -2 | 2 | 13 | 0 | -1 |
| 183 | 1011011111 | 2 | 2 | 17 | 0 | 1 | 0011011111 | -2 | 2 | 17 | 1 | 1 |
| 184 | 1011011010 | 2 | 3 | 25 | 0 | 1 | 0011011010 | -2 | 3 | 25 | 0 | 1 |
| 185 | 1011001001 | 2 | 3 | 21 | 1 | -1 | 0011001001 | -2 | 3 | 21 | 0 | -1 |
| 186 | 1011001011 | 2 | 3 | 25 | 0 | 1 | 0011001011 | -2 | 3 | 25 | 1 | 1 |
| 187 | 1011001110 | 2 | 3 | 33 | 0 | 1 | 0011001110 | -2 | 3 | 33 | 1 | 1 |
| 188 | 1011000100 | 2 | 4 | 45 | 0 | 1 | 0011000100 | -2 | 4 | 45 | 1 | 1 |
| 189 | 0100001110 | 2 | 3 | 37 | 0 | 1 | 1100001110 | -2 | 3 | 37 | 1 | 1 |
| 190 | 0100001011 | 2 | 3 | 29 | 0 | 1 | 1100001011 | -2 | 3 | 29 | 1 | 1 |
| 191 | 0100001001 | 2 | 3 | 25 | 1 | -1 | 1100001001 | -2 | 3 | 25 | 0 | -1 |
| 192 | 0100011010 | 2 | 3 | 29 | 0 | 1 | 1100011010 | -2 | 3 | 29 | 1 | 1 |
| 193 | 0100011111 | 2 | 2 | 21 | 0 | 1 | 1100011111 | -2 | 2 | 21 | 1 | 1 |
| 194 | 0100011101 | 2 | 2 | 17 | 1 | -1 | 1100011101 | -2 | 2 | 17 | 0 | -1 |
| 195 | 0100010101 | 2 | 2 | 17 | 0 | 1 | 1100010101 | -2 | 2 | 17 | 1 | 1 |
| 196 | 0100010111 | 2 | 2 | 13 | 1 | -1 | 1100010111 | -2 | 2 | 13 | 0 | -1 |
| 197 | 0100010010 | 2 | 2 | 13 | 1 | -1 | 1100010010 | -2 | 2 | 13 | 0 | -1 |
| 198 | 0100110010 | 2 | 3 | 25 | 0 | 1 | 1100110010 | -2 | 3 | 25 | 1 | 1 |
| 199 | 0100110111 | 2 | 2 | 17 | 0 | 1 | 1100110111 | -2 | 2 | 17 | 1 | 1 |
| 200 | 0100110101 | 2 | 2 | 13 | 1 | -1 | 1100110101 | -2 | 2 | 13 | 0 | -1 |
| 201 | 0100111101 | 2 | 2 | 13 | 0 | 1 | 1100111101 | -2 | 2 | 13 | 1 | 1 |
| 202 | 0100111111 | 2 | 2 | 9 | 1 | -1 | 1100111111 | -2 | 2 | 9 | 0 | -1 |
| 203 | 0100111010 | 2 | 2 | 9 | 1 | -1 | 1100111010 | -2 | 2 | 9 | 0 | -1 |
| 204 | 0100101001 | 2 | 2 | 13 | 0 | 1 | 1100101001 | -2 | 2 | 13 | 1 | 1 |
| 205 | 0100101011 | 2 | 2 | 9 | 1 | -1 | 1100101011 | -2 | 2 | 9 | 0 | -1 |
| 206 | 0100101110 | 2 | 2 | 9 | 1 | -1 | 1100101110 | -2 | 2 | 9 | 0 | -1 |
| 207 | 0100100100 | 2 | 2 | 13 | 1 | -1 | 1100100100 | -2 | 2 | 13 | 0 | -1 |
| 208 | 0101100010 | 2 | 3 | 25 | 0 | 1 | 1101100010 | -2 | 3 | 25 | 1 | 1 |
| 209 | 0101100111 | 2 | 2 | 17 | 0 | 1 | 1101100111 | -2 | 2 | 17 | 1 | 1 |
| 210 | 0101100101 | 2 | 2 | 13 | 1 | -1 | 1101100101 | -2 | 2 | 13 | 0 | -1 |
| 211 | 0101101101 | 2 | 2 | 13 | 0 | 1 | 1101101101 | -2 | 2 | 13 | 1 | 1 |
| 212 | 0101101111 | 2 | 2 | 9 | 1 | -1 | 1101101111 | -2 | 2 | 9 | 0 | -1 |
| 213 | 0101101010 | 2 | 2 | 9 | 1 | -1 | 1101101010 | -2 | 2 | 9 | 0 | -1 |
| 214 | 0101111001 | 2 | 2 | 13 | 0 | 1 | 1101111001 | -2 | 2 | 13 | 1 | 1 |
| 215 | 0101111011 | 2 | 2 | 9 | 1 | -1 | 1101111011 | -2 | 2 | 9 | 0 | -1 |
| 216 | 0101111110 | 2 | 2 | 9 | 1 | -1 | 1101111110 | -2 | 2 | 9 | 0 | -1 |
| 217 | 0101110100 | 2 | 2 | 13 | 1 | -1 | 1101110100 | -2 | 2 | 13 | 0 | -1 |
| 218 | 0101010001 | 2 | 2 | 17 | 0 | 1 | 1101010001 | -2 | 2 | 17 | 1 | 1 |
| 219 | 0101010011 | 2 | 2 | 13 | 1 | -1 | 1101010011 | -2 | 2 | 13 | 0 | -1 |
| 220 | 0101010110 | 2 | 2 | 13 | 1 | -1 | 1101010110 | -2 | 2 | 13 | 0 | -1 |
| 221 | 0101011100 | 2 | 2 | 17 | 1 | -1 | 1101011100 | -2 | 2 | 17 | 0 | -1 |
| 222 | 0111000010 | 2 | 3 | 29 | 0 | 1 | 1111000010 | -2 | 3 | 29 | 1 | 1 |

## FIG. 6E

| 223 | 0111000111 | 2 | 2 | 21 | 0 | 1 | 1111000111 | -2 | 2 | 21 | 1 | 1 |
|-----|------------|---|---|----|---|----|------------|----|---|----|---|----|
| 224 | 0111000101 | 2 | 2 | 17 | 1 | -1 | 1111000101 | -2 | 2 | 17 | 0 | -1 |
| 225 | 0111001101 | 2 | 2 | 17 | 0 | 1 | 1111001101 | -2 | 2 | 17 | 1 | 1 |
| 226 | 0111001111 | 2 | 2 | 13 | 1 | -1 | 1111001111 | -2 | 2 | 13 | 0 | -1 |
| 227 | 0111001010 | 2 | 2 | 13 | 1 | -1 | 1111001010 | -2 | 2 | 13 | 0 | -1 |
| 228 | 0111011001 | 2 | 2 | 17 | 0 | 1 | 1111011001 | -2 | 2 | 17 | 1 | 1 |
| 229 | 0111011011 | 2 | 2 | 13 | 1 | -1 | 1111011011 | -2 | 2 | 13 | 0 | -1 |
| 230 | 0111011110 | 2 | 2 | 13 | 1 | -1 | 1111011110 | -2 | 2 | 13 | 0 | -1 |
| 231 | 0111010100 | 2 | 2 | 17 | 1 | -1 | 1111010100 | -2 | 2 | 17 | 0 | -1 |
| 232 | 0111110001 | 2 | 2 | 21 | 0 | 1 | 1111110001 | -2 | 2 | 21 | 1 | 1 |
| 233 | 0111110011 | 2 | 2 | 17 | 1 | -1 | 1111110011 | -2 | 2 | 17 | 0 | -1 |
| 234 | 0111110110 | 2 | 2 | 17 | 1 | -1 | 1111110110 | -2 | 2 | 17 | 0 | -1 |
| 235 | 0111111100 | 2 | 2 | 21 | 1 | -1 | 1111111100 | -2 | 2 | 21 | 0 | -1 |
| 236 | 0110100001 | 2 | 3 | 29 | 0 | 1 | 1110100001 | -2 | 3 | 29 | 1 | 1 |
| 237 | 0110100011 | 2 | 3 | 25 | 1 | -1 | 1110100011 | -2 | 3 | 25 | 0 | -1 |
| 238 | 0110100110 | 2 | 3 | 25 | 1 | -1 | 1110100110 | -2 | 3 | 25 | 0 | -1 |
| 239 | 0110101100 | 2 | 3 | 29 | 1 | -1 | 1110101100 | -2 | 3 | 29 | 0 | -1 |
| 240 | 0010000111 | 2 | 3 | 29 | 0 | 1 | 1010000111 | -2 | 3 | 29 | 1 | 1 |
| 241 | 0010000101 | 2 | 3 | 25 | 1 | -1 | 1010000101 | -2 | 3 | 25 | 0 | -1 |
| 242 | 0010001101 | 2 | 3 | 25 | 0 | 1 | 1010001101 | -2 | 3 | 25 | 1 | 1 |
| 243 | 0010001111 | 2 | 3 | 21 | 1 | -1 | 1010001111 | -2 | 3 | 21 | 0 | -1 |
| 244 | 0010001010 | 2 | 3 | 21 | 1 | -1 | 1010001010 | -2 | 3 | 21 | 0 | -1 |
| 245 | 0010011001 | 2 | 3 | 25 | 0 | 1 | 1010011001 | -2 | 3 | 25 | 1 | 1 |
| 246 | 0010011011 | 2 | 3 | 21 | 1 | -1 | 1010011011 | -2 | 3 | 21 | 0 | -1 |
| 247 | 0010011110 | 2 | 3 | 21 | 1 | -1 | 1010011110 | -2 | 3 | 21 | 0 | -1 |
| 248 | 0010010100 | 2 | 3 | 25 | 1 | -1 | 1010010100 | -2 | 3 | 25 | 0 | -1 |
| 249 | 0010110001 | 2 | 3 | 29 | 0 | 1 | 1010110001 | -2 | 3 | 29 | 1 | 1 |
| 250 | 0010110011 | 2 | 3 | 25 | 1 | -1 | 1010110011 | -2 | 3 | 25 | 0 | -1 |
| 251 | 0010110110 | 2 | 3 | 25 | 1 | -1 | 1010110110 | -2 | 3 | 25 | 0 | -1 |
| 252 | 0010111100 | 2 | 3 | 29 | 1 | -1 | 1010111100 | -2 | 3 | 29 | 0 | -1 |
| 253 | 0011100001 | 2 | 3 | 37 | 0 | 1 | 1011100001 | -2 | 3 | 37 | 1 | 1 |
| 254 | 0011100011 | 2 | 3 | 33 | 1 | -1 | 1011100011 | -2 | 3 | 33 | 0 | -1 |
| 255 | 0011100110 | 2 | 3 | 33 | 1 | -1 | 1011100110 | -2 | 3 | 33 | 0 | -1 |
| 256 | 0011101100 | 2 | 3 | 37 | 1 | -1 | 1011101100 | -2 | 3 | 37 | 0 | -1 |

# F I G. 7

*F I G. 8*

# FIG. 9